# EUROPEAN PATENT APPLICATION

(11) **EP 4 636 123 A1**
(43) Date of publication of application: **22.10.2025**
(21) Application number: 23903468.9
(22) Date of filing: 11.12.2023
(51) Int. Cl.: C23C 14/04

(54) **MASK MANUFACTURING METHOD, AND MASK**

(30) Priority: 13.12.2022 JP 2022198893
(71) Applicant: Dai Nippon Printing Co., Ltd., Tokyo 162-8001 (JP)
(72) Inventor: HASHIMOTO, Katsumi, Tokyo 162-8001 (JP)
(74) Representative: Müller-Boré & Partner Patentanwälte PartG mbB
(86) International application number: PCT/JP2023/044200
(87) International publication number: WO 2024/128182

(57) **Abstract**

[Abstract] A mask manufacturing method may include: a step for preparing a substrate including a first substrate surface and a second substrate surface located opposite the first substrate surface; a step for forming a first insulation layer including a first insulation surface facing the second substrate surface, a second insulation surface located opposite the first insulation surface, and an insulation opening extending through from the first insulation surface to the second insulation surface; a step for forming a first metallic layer in the insulation opening, the first metallic layer including a first metallic surface facing the second substrate surface and a second metallic surface located opposite the first metallic surface; a step for removing the first insulation layer surrounded by the first metallic layer in plan view; and a step for forming a first opening in the substrate, the first opening overlapping the first metallic layer in plan view.

## Description

### Technical Field

Embodiments of the present disclosure relate to mask manufacturing methods and masks.

### Background Art

A vapor deposition method is known as a method for forming a precise pattern. In the vapor deposition method, a mask that has an opening is first combined with a substrate. Subsequently, a vapor deposition material is adhered to the substrate via the opening in the mask. This enables a vapor deposition layer that contains the vapor deposition material to be formed on the substrate in a pattern that corresponds to the pattern of the opening in the mask. For example, the vapor deposition method is used as a method for forming pixels of an organic EL display device.

For example, Patent Literature 1 discloses a vapor deposition mask that includes a metal mask provided with slits and that also includes a resin mask stacked on the metal mask and provided with openings overlapping the slits. The resin mask is composed of a resin material, such as polyimide resin. The metal mask is joined to a frame in a state where tension is applied to the metal mask.

### Citation List

### Patent Literature

PTL 1: Japanese Unexamined Patent Application Publication No. 2013-163864

### Disclosure of Invention

In a case where two layers containing different materials are stacked, warpage may sometimes occur in the mask due to different thermal expansion coefficients of the two layers.

A mask manufacturing method according to an embodiment of the present disclosure may include: a substrate preparation step for preparing a substrate including a first substrate surface and a second substrate surface located opposite the first substrate surface; a first-insulation-layer forming step for forming a first insulation layer including a first insulation surface facing the second substrate surface, a second insulation surface located opposite the first insulation surface, and an insulation opening extending through from the first insulation surface to the second insulation surface; a first-metallic-layer forming step for forming a first metallic layer in the insulation opening, the first metallic layer including a first metallic surface facing the second substrate surface and a second metallic surface located opposite the first metallic surface; an insulation layer removal step for removing the first insulation layer surrounded by the first metallic layer in plan view; and a substrate processing step for forming a first opening in the substrate, the first opening overlapping the first metallic layer in plan view.

According to the embodiment of the present disclosure, an occurrence of warpage in the mask can be suppressed.

### Brief Description of Drawings

[Fig. 1] Fig. 1 is a plan view illustrating an example of an organic device.
[Fig. 2] Fig. 2 illustrates an example of a vapor deposition apparatus including a mask.
[Fig. 3] Fig. 3 is a plan view illustrating an example of the mask as viewed from an entrance surface.
[Fig. 4] Fig. 4 is a plan view illustrating an example of the mask as viewed from an exit surface.
[Fig. 5] Fig. 5 is a cross-sectional view of the mask taken along line V-V in Fig. 3.
[Fig. 6] Fig. 6 is a cross-sectional view illustrating an example of a first region.
[Fig. 7] Fig. 7 is a cross-sectional view illustrating an example of a twenty-first region.
[Fig. 8] Fig. 8 is a cross-sectional view illustrating an example of a step for forming an intermediate layer.
[Fig. 9] Fig. 9 is a cross-sectional view illustrating an example of a step for forming a first insulation layer.
[Fig. 10A] Fig. 10A is a cross-sectional view illustrating an example of a step for forming insulation openings in the first insulation layer.
[Fig. 10B] Fig. 10B is a plan view illustrating an example of a step for forming the insulation openings in the first insulation layer.
[Fig. 11A] Fig. 11A is a cross-sectional view illustrating an example of a step for forming first metallic layers.
[Fig. 11B] Fig. 11B is a plan view illustrating the example of the step for forming the first metallic layers.
[Fig. 12] Fig. 12 is a cross-sectional view illustrating an example of a step for polishing a second metallic surface of each first metallic layer.
[Fig. 13] Fig. 13 is a cross-sectional view illustrating an example of a step for forming a first protection layer.
[Fig. 14A] Fig. 14A is a cross-sectional view illustrating an example of a step for removing a part of the first insulation layer.
[Fig. 14B] Fig. 14B is a plan view illustrating the example of the step for removing the part of the first insulation layer.
[Fig. 15] Fig. 15 is a cross-sectional view illustrating an example of a step for forming a second protection layer and a resist layer.
[Fig. 16] Fig. 16 is a cross-sectional view illustrating an example of a step for processing a substrate.
[Fig. 17] Fig. 17 is a cross-sectional view illustrating an example of a step for removing the second protection layer and the resist layer.
[Fig. 18] Fig. 18 is a cross-sectional view illustrating an example of warpage occurring in a multilayer body including the substrate and the first metallic layer.
[Fig. 19] Fig. 19 is a cross-sectional view illustrating an example of warpage occurring in a mask according to a comparative embodiment.
[Fig. 20] Fig. 20 is a cross-sectional view illustrating an example of warpage occurring in the multilayer body including the substrate and the first insulation layer.
[Fig. 21] Fig. 21 is a cross-sectional view illustrating an example of the mask according to the embodiment.
[Fig. 22] Fig. 22 is a cross-sectional view illustrating an example of a step for forming the first insulation layer in accordance with a first modification.
[Fig. 23] Fig. 23 is a cross-sectional view illustrating an example of a step for forming the first metallic layers in accordance with the first modification.
[Fig. 24] Fig. 24 is a cross-sectional view illustrating an example of a step for polishing the second metallic surface of each first metallic layer in accordance with the first modification.
[Fig. 25] Fig. 25 is a cross-sectional view illustrating an example of the substrate in accordance with a second modification.
[Fig. 26] Fig. 26 is a cross-sectional view illustrating an example of a step for forming the first insulation layer in accordance with the second modification.
[Fig. 27] Fig. 27 is a cross-sectional view illustrating an example of a step for forming the first metallic layers in accordance with the second modification.
[Fig. 28] Fig. 28 is a cross-sectional view illustrating an example of a step for removing a first oxide film in accordance with the second modification.
[Fig. 29] Fig. 29 is a cross-sectional view illustrating an example of a step for polishing the second metallic surface of each first metallic layer in accordance with the second modification.
[Fig. 30] Fig. 30 is a cross-sectional view illustrating an example of a mask according to the second modification.
[Fig. 31] Fig. 31 is a cross-sectional view illustrating an example of a step for forming recesses in a second substrate surface of the substrate in accordance with a third modification.
[Fig. 32] Fig. 32 is a cross-sectional view illustrating an example of a step for forming a second insulation layer in accordance with the third modification.
[Fig. 33] Fig. 33 is a cross-sectional view illustrating an example of a step for polishing the second insulation layer in accordance with the third modification.
[Fig. 34] Fig. 34 is a cross-sectional view illustrating an example of a step for forming the first insulation layer in accordance with the third modification.
[Fig. 35] Fig. 35 is a cross-sectional view illustrating an example of a mask according to the third modification.
[Fig. 36] Fig. 36 is a cross-sectional view illustrating an example of a step for forming openings in the first protection layer in accordance with a fourth modification.
[Fig. 37] Fig. 37 is a cross-sectional view illustrating an example of a step for forming third openings in the first insulation layer in accordance with the fourth modification.
[Fig. 38] Fig. 38 is a cross-sectional view illustrating an example of a step for forming second metallic layers in the third openings in accordance with the fourth modification.
[Fig. 39] Fig. 39 is a cross-sectional view illustrating an example of a mask according to the fourth modification.
[Fig. 40] Fig. 40 is a cross-sectional view illustrating the example of the mask according to the fourth modification.
[Fig. 41] Fig. 41 is a cross-sectional view illustrating an example of a step for forming first holes in the first insulation layer in accordance with a fifth modification.
[Fig. 42] Fig. 42 is a cross-sectional view illustrating an example of a step for forming second holes in the first insulation layer in accordance with the fifth modification.
[Fig. 43] Fig. 43 is a cross-sectional view illustrating an example of a step for forming the first metallic layers in accordance with the fifth modification.
[Fig. 44] Fig. 44 is a cross-sectional view illustrating an example of a mask according to the fifth modification.
[Fig. 45] Fig. 45 is a cross-sectional view illustrating an example of the first region of the mask according to the fifth modification.
[Fig. 46] Fig. 46 is a plan view illustrating an example of a mask according to a sixth modification.
[Fig. 47] Fig. 47 is a cross-sectional view illustrating an example of the mask according to the sixth modification.
[Fig. 48] Fig. 48 illustrates an example of a device including an organic device.
[Fig. 49] Fig. 49 is a graph illustrating results obtained by observing the shape of the substrate in accordance with an example.

### Description of Embodiments

In the present description and the drawings, terms, such as a "substrate", a "sheet", and a "film", implying a substance on which a structure is based are not distinguished from each other only based on different names, unless otherwise specifically noted.

In the present description and the drawings, for example, terms, such as "parallel" and "perpendicular", and the values of a length and an angle that specify shapes, geometrical conditions, and the degrees thereof are not limited to strict meanings but are interpreted to an extent that similar functions may be expected, unless otherwise specifically noted.

In the present description and the drawings, in a case where a certain component, such as a member or a region, is "on" or "under", "on an upper side of" or "on a lower side of", or "above" or "below" another component, such as another member or another region, such a case includes a case where the component is in direct contact with the other component, unless otherwise specifically noted. The aforementioned case also includes a case where another component is between the component and the other component, that is, a case where the component and the other component are indirectly connected to each other. As for the terms "on", "upper side", and "above", or "under", "lower side", and "below", an up-down direction may be inverted, unless otherwise specifically noted.

In the present description, if there are multiple upper limit candidates and multiple lower limit candidates that are related to a certain parameter, a numerical range for the parameter may be a combination of one arbitrarily selected upper limit candidate and one arbitrarily selected lower limit candidate. A conceivable example is a case where "For example, a parameter B is A1 or more, may be A2 or more, or may be A3 or more. For example, the parameter B is A4 or less, may be A5 or less, or may be A6 or less". In this case, the numerical range for the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the present description and the drawings, a state where a surface of an element A "faces" a surface of an element B includes not only a case where the surface of the element A is in contact with the surface of the element B but also a case where an element C is located between the surface of the element A and the surface of the element B, unless otherwise specifically noted. Specifically, the term "face" represents the orientations of two surfaces.

In the present description and the drawings, identical sections or sections with similar functions are designated by the same reference sign or similar reference signs, unless otherwise specifically noted, and redundant descriptions thereof are sometimes omitted. For the sake of convenience, the dimensional ratios in the drawings may sometimes differ from actual ratios, and some components may sometimes be omitted from the drawings.

In the present description and the drawings, an embodiment in the present description may be combined with another example so long as contractions do not occur, unless otherwise specifically noted. Moreover, other examples may be combined with each other so long as contractions do not occur.

In the present description and the drawings, if two or more steps or processes related to a method, such as a manufacturing method, are disclosed, another undisclosed step or process may be performed between the disclosed steps or processes, unless otherwise specifically noted. The order of the disclosed steps or processes is arbitrary so long as contractions do not occur.

An embodiment in the present description relates to an example where a mask is used to form an organic layer or an electrode on a substrate when an organic EL display device is manufactured. However, the use of the mask is not particularly limited, and the present embodiment may be used for masks that are used for various purposes. For example, the mask according to the present embodiment may be used to form an electrode of a device that displays or projects an image or a video image for expressing virtual reality, that is, so-called VR, or augmented reality, that is, so-called AR. In addition, the mask according to the present embodiment may be used to form an electrode of a display device other than an organic EL display device, such as an electrode of a liquid-crystal display device. Moreover, the mask according to the present embodiment may be used to form an electrode of an organic device other than a display device, such as an electrode of a pressure sensor.

A first aspect of the present disclosure provides a mask manufacturing method including:
a substrate preparation step for preparing a substrate including a first substrate surface and a second substrate surface located opposite the first substrate surface;
a first-insulation-layer forming step for forming a first insulation layer including a first insulation surface facing the second substrate surface, a second insulation surface located opposite the first insulation surface, and an insulation opening extending through from the first insulation surface to the second insulation surface;
a first-metallic-layer forming step for forming a first metallic layer in the insulation opening, the first metallic layer including a first metallic surface facing the second substrate surface and a second metallic surface located opposite the first metallic surface;
an insulation layer removal step for removing the first insulation layer surrounded by the first metallic layer in plan view;
and a substrate processing step for forming a first opening in the substrate, the first opening overlapping the first metallic layer in plan view.

A second aspect of the present disclosure may include the following aspect in the mask manufacturing method according to the first aspect described above. The mask may include an intermediate layer that contains metal and that is located between the first metallic surface and the second substrate surface as well as between the first insulation surface and the second substrate surface.

A third aspect of the present disclosure may include the following aspect in the mask manufacturing method according to the first or second aspect described above. The mask manufacturing method may further comprise an intermediate layer removal step for removing the intermediate layer overlapping the first opening in plan view, the intermediate layer removal step being performed subsequent to the substrate processing step.

A fourth aspect of the present disclosure may include the following aspect in the mask manufacturing method according to any one of the first to third aspects described above. The first-metallic-layer forming step may include a plating step.

A fifth aspect of the present disclosure may include the following aspect in the mask manufacturing method according to any one of the first to third aspects described above. The first-metallic-layer forming step may include a physical deposition step.

A sixth aspect of the present disclosure may include the following aspect in the mask manufacturing method according to any one of the first to fifth aspects described above. The mask manufacturing method may further include a first polishing step for polishing a part of the first metallic layer, the part protruding from the insulation opening, the first polishing step being performed subsequent to the first-metallic-layer forming step.

A seventh aspect of the present disclosure may include the following aspect in the mask manufacturing method according to any one of the first to sixth aspects described above. The mask manufacturing method may further include a step for forming a protection layer covering the first metallic layer, the step being performed subsequent to the insulation layer removal step and prior to the substrate processing step.

An eighth aspect of the present disclosure may include the following aspect in the mask manufacturing method according to any one of the first to seventh aspects described above. The first insulation layer surrounded by the insulation opening in plan view may have a third dimension at the first insulation surface and may have a fourth dimension at the second insulation surface, the fourth dimension being smaller than the third dimension.

A ninth aspect of the present disclosure may include the following aspect in the mask manufacturing method according to any one of the first to eighth aspects described above. The first-insulation-layer forming step may include a step for forming a first hole in the second insulation surface and a step for forming a second hole extending from the first hole to the first insulation surface.

A tenth aspect of the present disclosure may include the following aspect in the mask manufacturing method according to any one of the first to ninth aspects described above. A multilayer body including the substrate and the first insulation layer may have a curved shape that is convex in a direction extending from the first substrate surface toward the second substrate surface.

An eleventh aspect of the present disclosure provides a mask including:
a substrate including a first substrate surface, a second substrate surface located opposite the first substrate surface, and at least one first opening extending through from the first substrate surface to the second substrate surface;
a first metallic layer including a first metallic surface that overlaps the first opening in plan view and that partially faces the second substrate surface, a second metallic surface located opposite the first metallic surface, a plurality of second openings that extend through from the first metallic surface to the second metallic surface and that overlap the first opening in plan view, and a metallic outer wall surface located between the first metallic surface and the second metallic surface; and
a first insulation layer including a first insulation surface facing the second substrate surface, a second insulation surface located opposite the first insulation surface, and an insulation wall surface that is located between the first insulation surface and the second insulation surface and that is in contact with the metallic outer wall surface.

A twelfth aspect of the present disclosure may include the following aspect in the mask according to the eleventh aspect described above. The mask may further include an intermediate layer that contains metal and that is located between the first metallic surface and the second substrate surface as well as between the first insulation surface and the second substrate surface.

A thirteenth aspect of the present disclosure may include the following aspect in the mask according to the eleventh or twelfth aspect described above. The substrate may contain silicon or a silicon compound.

A fourteenth aspect of the present disclosure may include the following aspect in the mask according to any one of the eleventh to thirteenth aspects described above. The first insulation layer may contain a silicon oxide.

A fifteenth aspect of the present disclosure may include the following aspect in the mask according to any one of the eleventh to fourteenth aspects described above. The second metallic surface and the second insulation surface may be located on the same plane.

A sixteenth aspect of the present disclosure may include the following aspect in the mask according to any one of the eleventh to fifteenth aspects described above. Each second opening may have a first dimension at the first metallic surface and a second dimension at the second metallic surface, the second dimension being smaller than the first dimension.

A seventeenth aspect of the present disclosure may include the following aspect in the mask according to any one of the eleventh to sixteenth aspects described above. The substrate may include a second oxide film constituting the second substrate surface.

An eighteenth aspect of the present disclosure may include the following aspect in the mask according to any one of the eleventh to seventeenth aspects described above. The substrate may include a second insulation layer located in a recess formed in the second substrate surface.

A nineteenth aspect of the present disclosure may include the following aspect in the mask according to the eighteenth aspect described above. The second insulation layer may contain a silicon oxide.

A twentieth aspect of the present disclosure may include the following aspect in the mask according to any one of the eleventh to nineteenth aspects described above. The first insulation layer may include a third opening extending through from the first insulation surface to the second insulation surface, and the mask may further include a second metallic layer located in the third opening.

Embodiments of the present disclosure will now be described in detail with reference to the drawings. The embodiments to be described below are examples of embodiments of the present disclosure and are not to be interpreted limitedly to these embodiments of the present disclosure.

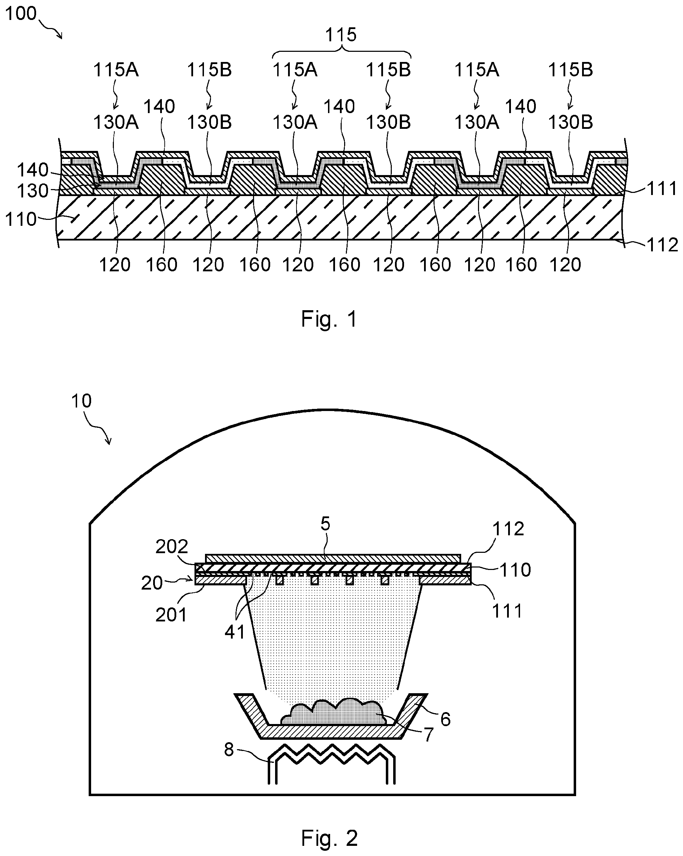

An organic device 100 including an organic layer formed by using a mask will now be described. The organic device 100 includes an organic layer or an electrode formed by using a mask. Fig. 1 is a cross-sectional view illustrating an example of the organic device 100.

The organic device 100 includes a substrate 110 and multiple elements 115 arranged in an in-plane direction of the substrate 110. The substrate 110 includes a first surface 111 and a second surface 112 located opposite the first surface 111. The elements 115 are located on the first surface 111. The elements 115 are, for example, pixels. The substrate 110 may include two or more types of elements 115. For example, the substrate 110 may include first elements 115A and second elements 115B. Although not illustrated, the substrate 110 may include third elements. The first elements 115A, the second elements 115B, and the third elements are, for example, red pixels, blue pixels, and green pixels.

The elements 115 may include first electrodes 120, organic layers 130 that are located on the first electrodes 120, and second electrodes 140 that are located on the organic layers 130.

The organic device 100 may include insulation layers 160 each of which is located between two of the first electrodes 120 adjacent to each other in plan view. For example, the insulation layers 160 contain polyimide. The insulation layers 160 may overlap ends of the first electrodes 120. The expression "in plan view" means that an object is viewed in the normal direction of a surface of a plate member, such as the substrate 110.

The substrate 110 may be an insulating member. The material used as the substrate 110 may be, for example, a rigid material with no flexibility, such as silicon, quartz glass, Pyrex (registered trademark) glass, or a synthetic quartz plate, or a flexible material with flexibility, such as a resin film, an optical resin plate, or thin glass. The substrate 110 may have a planar shape similar to that of a silicon wafer used in manufacturing semiconductor. In this case, the substrate 110 can be processed by using a device that performs a semiconductor manufacturing step. For example, the first electrodes 120 and the insulation layers 160 can be formed on the substrate 110 by using the device that performs the semiconductor manufacturing step.

The elements 115 are configured to achieve a certain function as a result of voltage being applied between the first electrodes 120 and the second electrodes 140 or electric current flowing between the first electrodes 120 and the second electrodes 140. For example, if the elements 115 are pixels of an organic EL display device, the elements 115 are capable of releasing light for forming a video image.

The first electrodes 120 contain a conductive material. For example, the first electrodes 120 contain metal, a conductive metal oxide, or another conductive inorganic material. The first electrodes 120 may contain a transparent conductive metal oxide, such as an indium tin oxide.

The organic layers 130 contain an organic material. When the organic layers 130 are supplied with electricity, the organic layers 130 can exhibit a certain function. The expression "supplied with electricity" means that voltage is applied to the organic layers 130 or electric current flows to the organic layers 130. The organic layers 130 used may be, for example, light-emitting layers that release light when supplied with electricity or layers with an optical transmittance or a refractive index that changes when supplied with electricity. The organic layers 130 may contain an organic semiconductor material.

As illustrated in Fig. 1, the organic layers 130 may include first organic layers 130A and second organic layers 130B. The first organic layers 130A are included in the first elements 115A. The second organic layers 130B are included in the second elements 115B. Although not illustrated, the organic layers 130 may include third organic layers that are included in the third elements. For example, the first organic layers 130A, the second organic layers 130B, and the third organic layers are red light-emitting layers, blue light-emitting layers, and green light-emitting layers.

When voltage is applied between the first electrodes 120 and the second electrodes 140, the organic layers 130 that are located therebetween are driven. If the organic layers 130 are light-emitting layers, light is released from the organic layers 130, and the light is extracted from the second electrodes 140 or the first electrodes 120 to the outside.

The organic layers 130 may further include, for example, a hole injection layer, a hole transport layer, an electron transport layer, and an electron injection layer.

The second electrodes 140 may contain a conductive material, such as metal. Examples of the material that can be used as the second electrodes 140 may include platinum, gold, silver, copper, iron, tin, chromium, aluminum, indium, lithium, sodium, potassium, calcium, magnesium, chromium, carbon, and an alloy thereof. As illustrated in Fig. 1, the second electrodes 140 may extend across two of the organic layers 130 adjacent to each other in plan view.

A method for forming the organic layers 130 on the substrate 110 by vapor deposition will now be described. Fig. 2 illustrates a vapor deposition apparatus 10. The vapor deposition apparatus 10 performs a vapor deposition process involving depositing a vapor deposition material on an object.

As illustrated in Fig. 2, the vapor deposition apparatus 10 may include a vapor deposition source 6, a heater 8, and a mask 20 therein. The vapor deposition apparatus 10 may further include an exhaust unit for creating a vacuum atmosphere in the vapor deposition apparatus 10. The vapor deposition source 6 is, for example, a crucible. The vapor deposition source 6 contains a vapor deposition material 7, such as an organic material or a metallic material. The heater 8 heats the vapor deposition source 6 to vaporize the vapor deposition material 7 in the vacuum atmosphere.

The mask 20 has an entrance surface 201, an exit surface 202, and second openings 41. The entrance surface 201 faces the vapor deposition source 6. The exit surface 202 is located opposite the entrance surface 201. The exit surface 202 faces the first surface 111 of the substrate 110. A portion of the vapor deposition material 7 entering the mask 20 via the exit surface 202 exits the exit surface 202 by passing through the second openings 41. The vapor deposition material 7 exiting the exit surface 202 adheres to the first surface 111 of the substrate 110. The exit surface 202 of the mask 20 may be in contact with the first surface 111 of the substrate 110.

As illustrated in FIG. 2, the vapor deposition apparatus 10 may include a magnet 5 disposed on the second surface 112 of the substrate 110. If the mask 20 contains a magnetic material, the magnet 5 can attract the mask 20 toward the substrate 110 by using a magnetic force. This enables a gap to be reduced or eliminated between the mask 20 and the substrate 110. Accordingly, an occurrence of a shadow during a vapor deposition step can be suppressed. In the present application, a shadow is a phenomenon where the thickness of the organic layers 130 near the wall surfaces of the second openings 41 is smaller than the thickness of the organic layers 130 at the centers of the second openings 41. A shadow occurs due to, for example, adhesion of the vapor deposition material 7 to a wall surface of the mask 20 or entry of the vapor deposition material 7 into a gap between the mask 20 and the substrate 110.

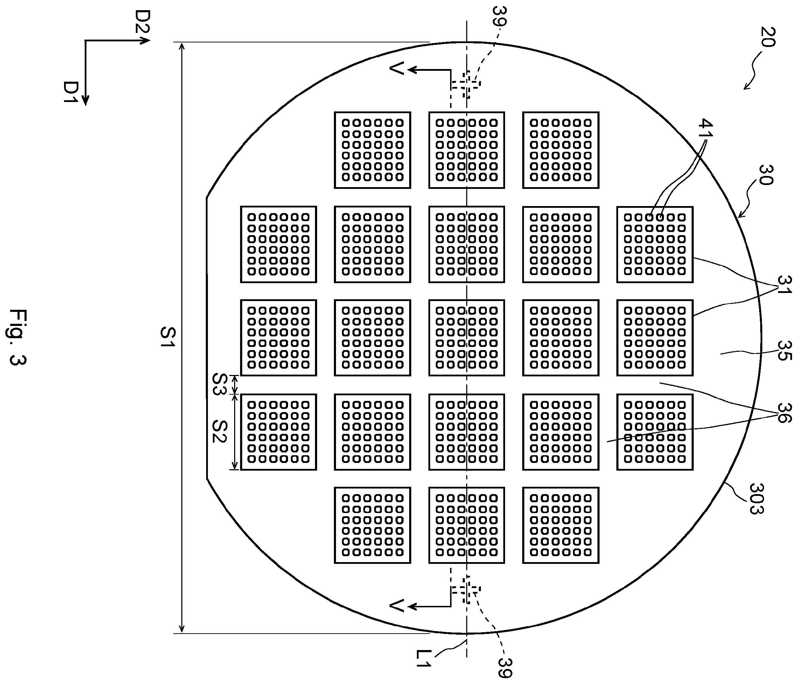

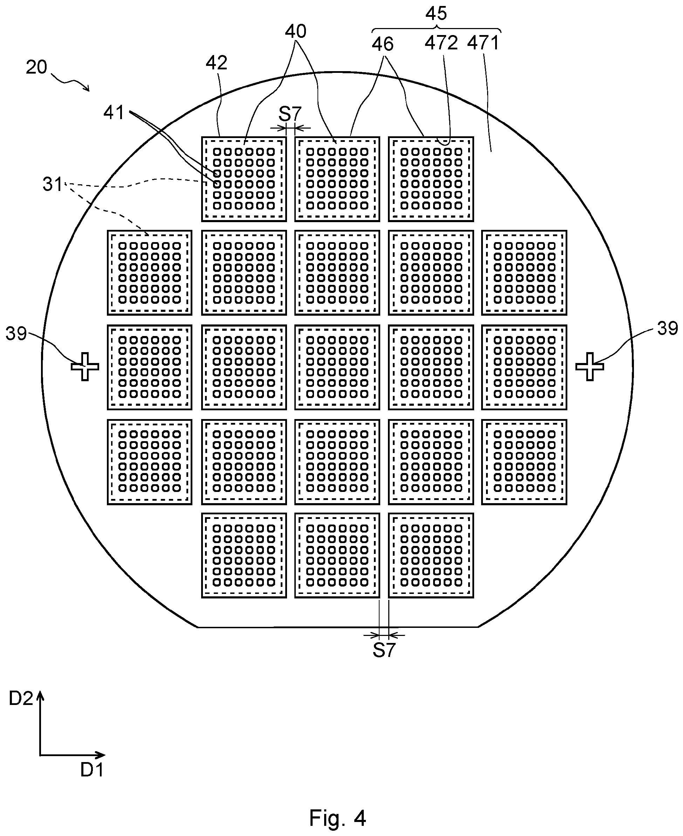

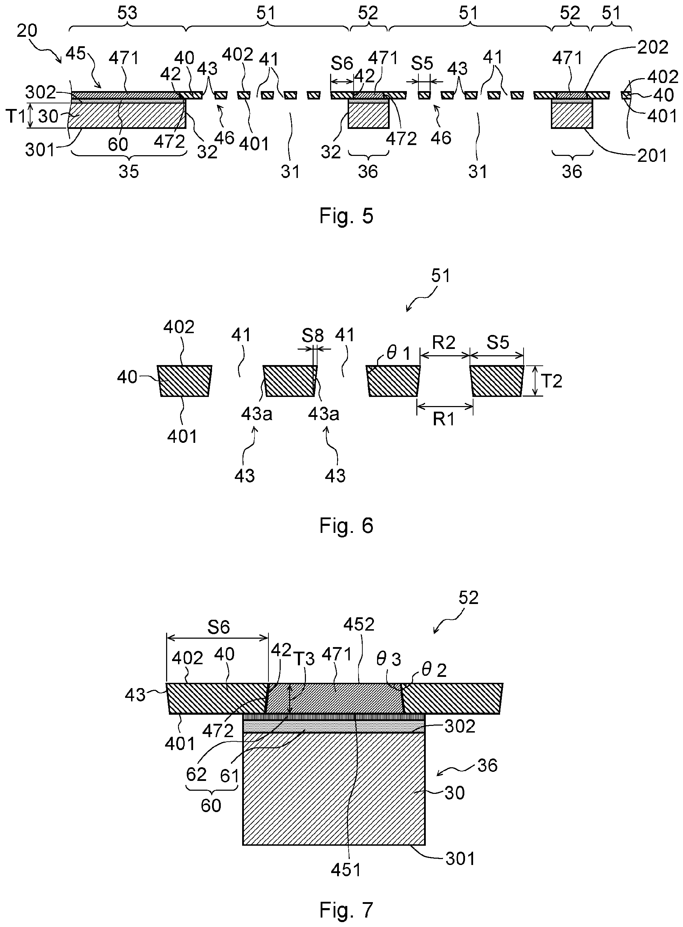

The mask 20 will now be described in detail. Fig. 3 is a plan view illustrating an example of the mask 20 as viewed from the entrance surface 201. Fig. 4 is a plan view illustrating an example of the mask 20 as viewed from the exit surface 202. Fig. 5 is a cross-sectional view of the mask 20 taken along line V-V in Fig. 3.

As illustrated in Fig. 5, the mask 20 includes a substrate 30, a first metallic layer 40, and a first insulation layer 45. The mask 20 may include an intermediate layer 60.

The substrate 30 includes a first substrate surface 301, a second substrate surface 302, a first opening 31, and first wall surfaces 32. The first substrate surface 301 may serve as the entrance surface 201. The second substrate surface 302 is located opposite the first substrate surface 301. The first wall surfaces 32 are located between the first substrate surface 301 and the second substrate surface 302.

The first opening 31 extends through from the first substrate surface 301 to the second substrate surface 302. As illustrated in Fig. 3, the substrate 30 may include multiple first openings 31. The multiple first openings 31 may be arranged in a first direction D1 and a second direction D2. The second direction D2 may be orthogonal to the first direction D1. The first direction D1 and the second direction D2 are parallel to the first substrate surface 301.

One first opening 31 may correspond to one screen of the organic EL display device. The mask 20 including the multiple first openings 31 can form patterns of organic layers corresponding to multiple screens simultaneously on the substrate 110. As illustrated in Fig. 3, each first opening 31 may have a rectangular contour in plan view.

Each first wall surface 32 faces the corresponding first opening 31. In the example illustrated in Fig. 3, the first wall surfaces 32 extend in the normal direction of the first substrate surface 301.

As illustrated in Fig. 3, a region of the substrate 30 where the first openings 31 are not provided may be segmented into an outer region 35 and an inner region 36. The inner region 36 is located between two of the first openings 31 adjacent to each other in plan view. The outer region 35 is located between an outer edge 303 of the substrate 30 and the first openings 31 in plan view. As illustrated in Fig. 3, the inner region 36 may extend in the first direction D1 and the second direction D2.

As illustrated in Fig. 3 and Fig. 4, the substrate 30 may include alignment marks 39. For example, the alignment marks 39 are provided on the second substrate surface 302. The alignment marks 39 may be provided on the first substrate surface 301. For example, the alignment marks 39 are used to adjust the relative position of the substrate 110 with respect to the mask 20. If the substrate 110 has properties that enable visible light to pass therethrough, the alignment marks 39 can be visually recognized through the substrate 110.

As illustrated in Fig. 3 and Fig. 4, the alignment marks 39 may have a cross-shaped contour in plan view. Although not illustrated, the alignment marks 39 may have a contour with a shape other than a cross shape, such as a rectangular shape or a circular shape. The alignment marks 39 may be located in the outer region 35 or may be located in the inner region 36.

The shape of the alignment marks 39 in cross section is arbitrary.

For example, each alignment mark 39 may include a recess located in the first substrate surface 301 or the second substrate surface 302. Each alignment mark 39 may include a hole extending through from the first substrate surface 301 to the second substrate surface 302. The recesses and the holes may be formed by etching the first substrate surface 301 or the second substrate surface 302. The recesses and the holes may be formed by irradiating the first substrate surface 301 or the second substrate surface 302 with laser light.

For example, each alignment mark 39 may include a layer located on the first substrate surface 301 or the second substrate surface 302. The layer is composed of a material different from that of the substrate 30.

The alignment marks 39 may be formed in a layer other than that of the substrate 30.

The substrate 30 contains silicon or a silicon compound. For example, the substrate 30 is fabricated by processing a silicon wafer. As illustrated in Fig. 3, the outer edge 303 of the substrate 30 may include a straight section. The straight section is also referred to as an orientation flat. Although not illustrated, the outer edge 303 may have a cutout. This cutout is also referred to as a notch. The orientation flat and the notch represent the crystal orientation of the silicon wafer.

For example, a maximum dimension S1 of the substrate 30 in plan view is 100 mm or more, may be 150 mm or more, or may be 200 mm or more. For example, the dimension S1 is 500 mm or less, may be 400 mm or less, or may be 300 mm or less.

For example, a dimension S2 of each first opening 31 in the direction in which the first openings 31 are arranged is 5 mm or more, may be 10 mm or more, or may be 20 mm or more. For example, the dimension S2 is 100 mm or less, may be 50 mm or less, or may be 30 mm or less.

For example, a distance S3 between two of the first openings 31 in the direction in which the first openings 31 are arranged is 0.1 mm or more, may be 0.5 mm or more, or may be 1.0 mm or more. For example, the distance S3 is 20 mm or less, may be 15 mm or less, or may be 10 mm or less.

The thickness of the substrate 30 is defined as a maximum thickness T1 of the outer region 35. For example, the thickness T1 is 50 µm or more, may be 100 µm or more, or may be 200 µm or more. For example, the thickness T1 is 1000 µm or less, may be 800 µm or less, or may be 600 µm or less.

The first metallic layer 40 will now be described. As illustrated in Fig. 4 and Fig. 5, the mask 20 includes multiple first metallic layers 40 arranged along the first substrate surface 301. For example, similar to the multiple first openings 31, the multiple first metallic layers 40 may be arranged in the first direction D1 and the second direction D2. The first metallic layers 40 overlap the first openings 31 in plan view. One first metallic layer 40 may overlap one first opening 31. The multiple first metallic layers 40 do not have to be connected to each other.

Each first metallic layer 40 includes multiple second openings 41. Each first metallic layer 40 is supported by the substrate 30. For example, the ends of each first metallic layer 40 are supported by the second substrate surface 302 of the substrate 30. A distance S7 between two of the first metallic layers 40 in the direction in which the first metallic layers 40 are arranged is smaller than the distance S3 between two of the first openings 31.

As illustrated in Fig. 5, each first metallic layer 40 includes a first metallic surface 401, a second metallic surface 402, the second openings 41, a metallic outer wall surface 42, and a metallic inner wall surface 43. The second openings 41 extend through from the first metallic surface 401 to the second metallic surface 402. The metallic outer wall surface 42 and the metallic inner wall surface 43 are located between the first metallic surface 401 and the second metallic surface 402. As illustrated in Fig. 4, the metallic outer wall surface 42 defines the outer edges of the first metallic layer 40 in plan view. The metallic outer wall surface 42 may be in contact with the first insulation layer 45. As illustrated in Fig. 5, the metallic inner wall surface 43 faces the second openings 41.

As illustrated in Fig. 4, a large part of each first metallic layer 40 overlaps the corresponding first opening 31 in plan view. Therefore, the large part of the first metallic surface 401 faces the first opening 31. As mentioned above, the ends of each first metallic layer 40 are fixed to the second substrate surface 302. Therefore, at the ends of the first metallic layer 40, the first metallic surface 401 faces the second substrate surface 302. Specifically, the first metallic surface 401 partially faces the second substrate surface 302.

One second opening 41 corresponds to one vapor deposition layer. One vapor deposition layer is, for example, one organic layer 130. A group of multiple second openings 41 formed in one first metallic layer 40 may correspond to one screen of the organic EL display device.

The first insulation layer 45 will now be described. As illustrated in Fig. 4 and Fig. 5, the first insulation layer 45 surrounds the first metallic layers 40 in plan view. For example, the first insulation layer 45 includes multiple insulation openings 46, and one first metallic layer 40 is located in each insulation opening 46. A part of the first insulation layer 45 that surrounds the insulation openings 46 is also referred to as a frame section 471. The frame section 471 includes insulation wall surfaces 472 facing the respective insulation openings 46.

Similar to the multiple first metallic layers 40, the multiple insulation openings 46 may be arranged in the first direction D1 and the second direction D2. The insulation openings 46 overlap the respective first openings 31 in plan view. One insulation opening 46 may overlap one first opening 31.

As illustrated in Fig. 5, the first insulation layer 45 includes a first insulation surface 451, a second insulation surface 452, the insulation openings 46, and the insulation wall surfaces 472. The insulation openings 46 extend through the first insulation layer 45 from the first insulation surface 451 to the second insulation surface 452. The insulation wall surfaces 472 are located between the first insulation surface 451 and the second insulation surface 452. As illustrated in Fig. 4, the insulation wall surfaces 472 define the outer edges of the insulation openings 46 in plan view. As illustrated in Fig. 5, the insulation wall surfaces 472 may be in contact with the metallic outer wall surfaces 42 of the first metallic layers 40.

In the following description, parts of the mask 20 that overlap the first openings 31 in plan view may also be referred to as first regions 51. A region of the mask 20 that does not overlap the first openings 31 in plan view may also be referred to as a second region. A region of the second region that is located between two of the first openings 31 in plan view may also be referred to as a twenty-first region 52. A region of the second region that is located between the outer edge 303 of the substrate 30 and each first opening 31 in plan view may also be referred to as a twenty-second region 53.

Fig. 6 is a cross-sectional view illustrating an example of the first region 51. The first region 51 includes the first metallic layer 40 having the second openings 41. Reference sign R1 denotes a dimension of each second opening 41 in the first metallic surface 401. Reference sign R2 denotes a dimension of each second opening 41 in the second metallic surface 402. The dimension R1 is also referred to as a first dimension. The dimension R2 is also referred to as a second dimension. A dimension of a vapor deposition layer to be formed on the substrate 110 in accordance with a vapor deposition step using the mask 20 is determined in accordance with the second dimension R2 of each second opening 41 in the second metallic surface 402.

The first dimension R1 may be larger than the second dimension R2. In other words, the second dimension R2 may be smaller than the first dimension R1. Accordingly, an occurrence of a shadow near each metallic inner wall surface 43 can be suppressed. The first dimension R1 and the second dimension R2 are determined in the direction in which the second openings 41 are arranged.

As illustrated in Fig. 6, each metallic inner wall surface 43 may include a tapered surface 43a that tapers away from the center of the corresponding second opening 41 from the second metallic surface 402 toward the first metallic surface 401. With the metallic inner wall surface 43 including the tapered surface 43a, the first dimension R1 can be made larger than the second dimension R2.

In Fig. 6, reference sign S8 denotes a width of the tapered surface 43a in the direction in which the second openings 41 are arranged. For example, the width S8 is 0.2 µm or more, may be 0.5 µm or more, or may be 1.0 µm or more. For example, the width S8 is 25 µm or less, may be 20 µm or less, or may be 10 µm or less.

In Fig. 6, reference sign θ1 denotes an angle formed between each metallic inner wall surface 43 and the second metallic surface 402. For example, the angle θ1 is 50° or more, may be 55° or more, or may be 60° or more. For example, the angle θ1 is less than 90°, may be 85° or less, or may be 80° or less.

A thickness T2 of each first metallic layer 40 is smaller than the thickness T1 of the substrate 30. For example, the thickness of the first metallic layer 40 is 25.0 µm or less, may be 10.0 µm or less, or may be 5.0 µm or less. Accordingly, an occurrence of a shadow can be suppressed. For example, the thickness T2 of each first metallic layer 40 is 0.5 µm or more, may be 1.0 µm or more, or may be 2.0 µm or more. Accordingly, an occurrence of, for example, a defect or deformation, such as a pin hole, in the first metallic layer 40 can be suppressed.

For example, a distance S5 between two of the metallic inner wall surfaces 43 in the direction in which the second openings 41 are arranged is 1.0 µm or more, may be 2.0 µm or more, or may be 3.0 µm or more. For example, the distance S5 is 25.0 µm or less, may be 10.0 µm or less, or may be 5.0 µm or less.

Each first metallic layer 40 contains metal. The metal may be a magnetic material or a nonmagnetic material. Examples of the magnetic material include nickel, iron, cobalt, and an alloy thereof. Examples of the nonmagnetic material include copper, aluminum, titanium, chromium, and an alloy thereof. Each first metallic layer 40 may contain a semiconductor. For example, each first metallic layer 40 may contain polycrystalline silicon. Each first metallic layer 40 may be constituted of a single layer, or may be constituted of multiple layers.

Fig. 7 is a cross-sectional view illustrating an example of the twenty-first region 52. The twenty-first region 52 includes the substrate 30 constituting the inner region 36, a part of the first metallic layer 40, and the frame section 471 of the first insulation layer 45. The first metallic surface 401 in the part of the first metallic layer 40 and the first insulation surface 451 of the frame section 471 face the second substrate surface 302 of the substrate 30. The intermediate layer 60 may be located between the substrate 30 and the part of the first metallic layer 40, as well as between the substrate 30 and the frame section 471.

As illustrated in Fig. 7, the second metallic surface 402 of the first metallic layer 40 and the second insulation surface 452 of the frame section 471 may be located on the same plane. For example, at the boundary between the first metallic layer 40 and the frame section 471, a step between the second metallic surface 402 and the second insulation surface 452 may be 1.0 µm or less.

For example, a thickness T3 of the first insulation layer 45 is 25.0 µm or less, may be 10.0 µm or less, or may be 5.0 µm or less. For example, the thickness T3 of the first insulation layer 45 is 0.5 µm or more, may be 1.0 µm or more, or may be 2.0 µm or more. The thickness T3 of the first insulation layer 45 may be the same as the thickness T2 of the first metallic layer 40. For example, a difference between the thickness T3 and the thickness T2 may be 1.0 µm or less.

As illustrated in Fig. 7, each insulation wall surface 472 of the frame section 471 may be in contact with the corresponding metallic outer wall surface 42 of the first metallic layer 40. In this case, the insulation wall surface 472 has a shape that corresponds to that of the metallic outer wall surface 42. For example, the sum of an angle θ2 and an angle θ3 may be 180°. The angle θ2 is an angle formed between the metallic outer wall surface 42 and the second metallic surface 402. The angle θ3 is an angle formed between the insulation wall surface 472 and the second insulation surface 452. The metallic outer wall surface 42 may overlap the substrate 30 in plan view. In other words, the metallic outer wall surface 42 does not have to overlap the corresponding first opening 31 in plan view.

For example, the angle θ2 is 50° or more, may be 55° or more, or may be 60° or more. For example, the angle θ2 is less than 90°, may be 85° or less, or may be 80° or less.

For example, the angle θ3 is more than 90°, may be 95° or more, or may be 100° or more. For example, the angle θ3 is 130° or less, may be 125° or less, or may be 120° or less.

Since the structure of the frame section 471 located in the twenty-second region 53 is identical to the structure of the aforementioned frame section 471 located in the twenty-first region 52, the description thereof will be omitted.

The first insulation layer 45 is configured to have stress-related properties different from those of the first metallic layers 40. For example, when the first metallic layers 40 apply tensile stress to the substrate 30, the first insulation layer 45 is configured to apply compressive stress to the substrate 30. When the first insulation layer 45 applies compressive stress to the substrate 30, the first insulation layer 45 can at least partially cancel out a force applied to the substrate 30 by the first metallic layers 40. Consequently, an occurrence of warpage in the mask 20 can be suppressed.

The material of the first insulation layer 45 is selected such that the first insulation layer 45 has stress-related properties different from those of the first metallic layers 40. The material of the first insulation layer 45 has insulating properties. For example, the first insulation layer 45 contains an oxide having insulating properties. The oxide is, for example, a silicon oxide.

In Fig. 6, reference sign S6 denotes a distance between the metallic inner wall surface 43 and the metallic outer wall surface 42 in the direction in which the second openings 41 are arranged. The distance S6 may be larger than the distance S5 between two of the metallic inner wall surfaces 43.

The intermediate layer 60 will now be described. The intermediate layer 60 includes a layer that fulfills a certain function with respect to the substrate 30 or each first metallic layer 40. For example, the intermediate layer 60 includes a stopper layer 61. The stopper layer 61 is located between the second substrate surface 302 of the substrate 30 and the part of the first metallic surface 401 of the first metallic layer 40, as well as between the second substrate surface 302 of the substrate 30 and the first insulation surface 451 of the first insulation layer 45. The stopper layer 61 may be in contact with the second substrate surface 302 of the substrate 30.

The stopper layer 61 may have a function for stopping etching in a step for processing the substrate 30 by etching. In detail, the stopper layer 61 has resistance against an etchant used for etching the substrate 30. The stopper layer 61 may contain metal, such as aluminum, an aluminum alloy, titanium, or a titanium alloy. The aluminum alloy contains, for example, aluminum and neodymium. The stopper layer 61 may contain an inorganic compound, such as a silicon oxide.

The thickness of the stopper layer 61 is not particularly limited so long as etching of each first metallic layer 40 can be suppressed in the step for processing the substrate 30. For example, the thickness of the stopper layer 61 may be smaller than the thickness of the first metallic layer 40, or may be larger than or equal to the thickness of the first metallic layer 40. For example, the thickness of the stopper layer 61 is 5 nm or more, may be 50 nm or more, or may be 75 nm or more. For example, the thickness of the stopper layer 61 is 100 µm or less, may be 50 µm or less, may be 10.0 µm or less, may be 5.0 µm or less, may be 1.0 µm or less, or may be 150 nm or less. The thickness of the stopper layer 61 can be reduced more with increasing resistance of the stopper layer 61 against the etchant for the substrate 30. It is particularly preferable that the thickness of the stopper layer 61 be 1.0 µm or less.

The intermediate layer 60 may include a seed layer 62. The seed layer 62 may be in contact with the part of the first metallic surface 401 of the first metallic layer 40 and the first insulation surface 451 of the first insulation layer 45. The seed layer 62 may be located between the stopper layer 61 and the first metallic surface 401, as well as between the stopper layer 61 and the first insulation surface 451.

The seed layer 62 carries electric charge to a plating solution when each first metallic layer 40 is to be formed by electrolytic plating. The seed layer 62 may contain metal. Examples of the metal include nickel, copper, titanium, aluminum, and an alloy thereof. The seed layer 62 may be constituted of a single layer, or may be constituted of multiple layers. For example, the seed layer 62 may include a first layer located on the stopper layer 61 and containing titanium, and a second layer located on the first layer and containing copper.

For example, the thickness of the seed layer 62 is 2.0 nm or more, may be 10.0 nm or more, or may be 30.0 nm or more. For example, the thickness of the seed layer 62 is 5.0 µm or less, may be 1.0 µm or less, or may be 150 nm or less.

The thicknesses of the respective layers, the dimensions of the components, the distances, and so on are measured by observing a cross-sectional image of the mask 20 by using a scanning electron microscope.

A manufacturing method for the mask 20 will now be described. First, a substrate preparation step for preparing the substrate 30 is performed. The substrate 30 used may be a silicon wafer. The first substrate surface 301 and the second substrate surface 302 of the substrate 30 may be polished to a mirror finish. An arithmetic average roughness Ra of each of the first substrate surface 301 and the second substrate surface 302 may be 1.5 nm or less, or may be 1.0 nm or less. The surface orientations of the first substrate surface 301 and the second substrate surface 302 may be (100), (110), and/or the like.

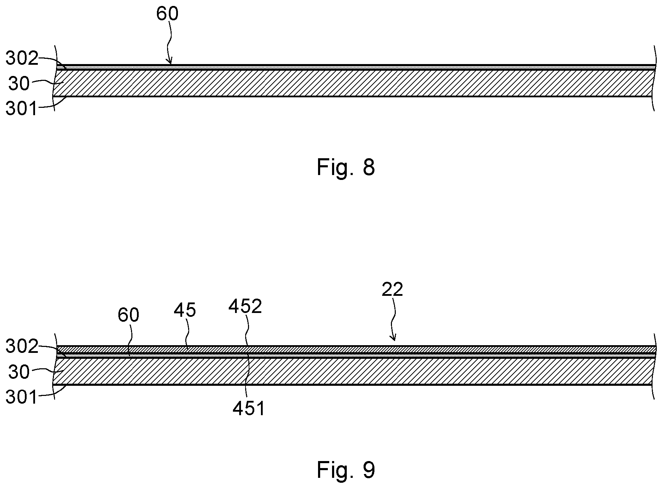

Subsequently, as illustrated in Fig. 8, the intermediate layer 60 is formed on the second substrate surface 302 of the substrate 30. The intermediate layer 60 includes, for example, the stopper layer 61. The intermediate layer 60 may include the stopper layer 61 and the seed layer 62. The intermediate layer 60 may be formed on the entire second substrate surface 302. For example, the intermediate layer 60 may be formed by physical deposition, such as sputtering, vapor deposition, or ion plating.

Then, as illustrated in Fig. 9, a step for forming the first insulation layer 45 on the intermediate layer 60 is performed. Accordingly, a multilayer body 22 at least including the substrate 30 and the first insulation layer 45 can be obtained. The first insulation layer 45 may be formed on the entire second substrate surface 302.

The first insulation layer 45 may be formed by chemical vapor deposition. For example, the first insulation layer 45 is formed by chemical vapor deposition using tetraethyl orthosilicate Si(OC₂H₅)₄ as a raw material. Tetraethyl orthosilicate is also referred to as TEOS.

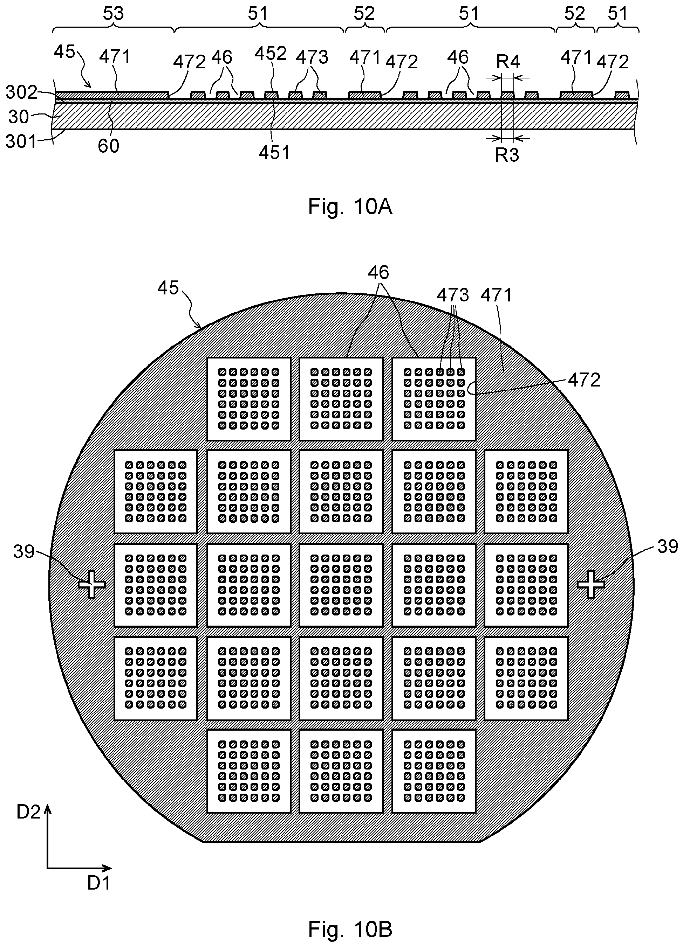

Subsequently, a step for forming the multiple insulation openings 46 in the first insulation layer 45 is performed. Fig. 10A and Fig. 10B are a cross-sectional view and a plan view, respectively, illustrating the first insulation layer 45 having the multiple insulation openings 46 formed therein. The multiple insulation openings 46 may be arranged in the first direction D1 and the second direction D2. Each of the multiple insulation openings 46 has a contour that corresponds to each first metallic layer 40 in plan view. As illustrated in Fig. 10B, the contour of each insulation opening 46 may be rectangular. Although not illustrated, the corners of the contour of each insulation opening 46 may be curved. The contour of each insulation opening 46 may have another shape, such as a circular shape. Each insulation opening 46 may be configured such that the contour of the insulation opening 46 surrounds the contour of the corresponding first opening 31 to be formed in a subsequent step. The contour shape of each insulation opening 46 may be similar to the contour shape of each first opening 31.

The first insulation layer 45 includes the frame section 471 that defines the contour of each insulation opening 46. The frame section 471 includes the insulation wall surfaces 472 facing the insulation openings 46. The first insulation layer 45 includes multiple island sections 473 surrounded by each insulation opening 46 in plan view. The aforementioned second openings 41 in the mask 20 are provided at the locations of the island sections 473.

Reference sign R3 denotes a dimension of each island section 473 at the first insulation surface 451. Reference sign R4 denotes a dimension of each island section 473 at the second insulation surface 452. The dimension R3 is also referred to as a third dimension. The dimension R4 is also referred to as a fourth dimension. The fourth dimension R4 may be smaller than the third dimension R3. Accordingly, the second dimension R2 of each second opening 41 can be made smaller than the first dimension R1. The third dimension R3 and the fourth dimension R4 are determined in the direction in which the island sections 473 are arranged.

The method for forming the insulation openings 46 in the first insulation layer 45 is not particularly limited. For example, the insulation openings 46 may be formed by dry etching using etching gas. The dry etching may be reactive ion etching.

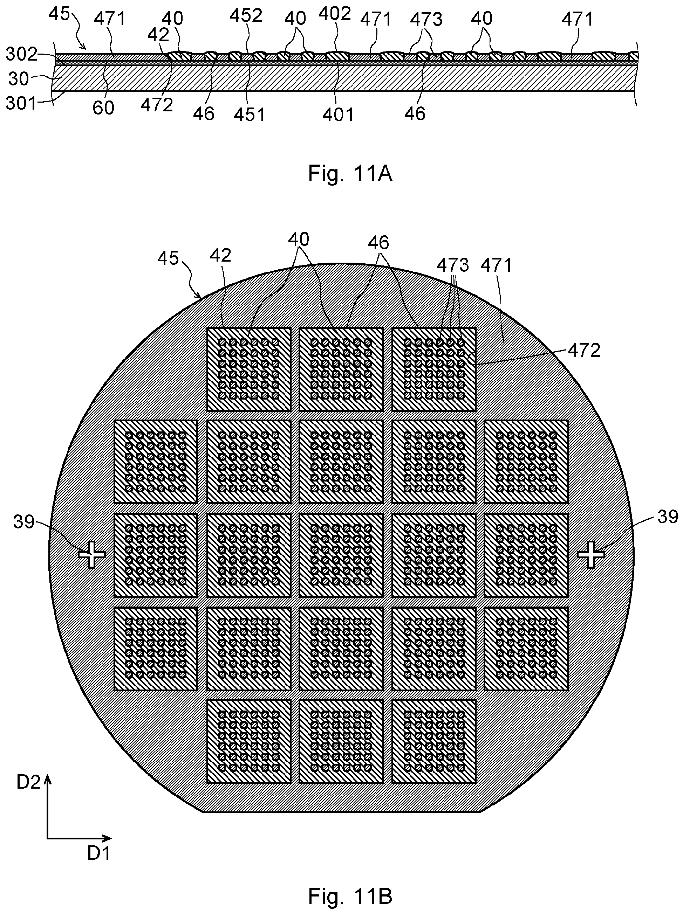

Subsequently, a first-metallic-layer forming step for forming the first metallic layers 40 in the respective insulation openings 46 is performed. Fig. 11A and Fig. 11B are a cross-sectional view and a plan view, respectively, illustrating the first metallic layers 40 formed in the respective insulation openings 46.

The first-metallic-layer forming step may include a plating step. Specifically, the first metallic layers 40 may be formed in accordance with the plating step. The plating step may be an electrolytic plating step, or may be a non-electrolytic plating step. In the case where the electrolytic plating step is to be performed, the intermediate layer 60 includes the seed layer 62. In the case where the electrolytic plating step is to be performed, a hole, a cutout, or the like for supplying electric current to the seed layer 62 may be formed in the first insulation layer 45.

The plating step involves supplying the insulation openings 46 with a plating solution containing metallic ions that constitute the first metallic layers 40. Accordingly, as illustrated in Fig. 11A and Fig. 11B, the first metallic layers 40 are formed in the respective insulation openings 46. In the planar direction of the first substrate surface 301 of the substrate 30, the first metallic layers 40 are in contact with the insulation wall surfaces 472 of the frame section 471 and with the wall surfaces of the island sections 473. The first metallic layers 40 are in contact with the intermediate layer 60 in the thickness direction of the substrate 30. As illustrated in Fig. 11A, the first metallic layers 40 may protrude upward from the insulation openings 46 in the thickness direction of the substrate 30. Specifically, the second metallic surface 402 of each first metallic layer 40 may be located higher than the second insulation surface 452 of the first insulation layer 45. The first metallic layers 40 do not have to be formed on the second insulation surface 452 of the first insulation layer 45.

The first-metallic-layer forming step may include an annealing step for heating the first metallic layers 40. Accordingly, distortion occurring inside the first metallic layers 40 can be reduced. In the annealing step, the substrate 30, the first metallic layers 40, and the first insulation layer 45 are maintained in an environment higher in temperature than room temperature. For example, the temperature in the annealing step is 120°C or higher, may be 140°C or higher, or may be 150°C or higher. For example, the temperature in the annealing step is 250°C or lower, may be 220°C or lower, or may be 200°C or lower.

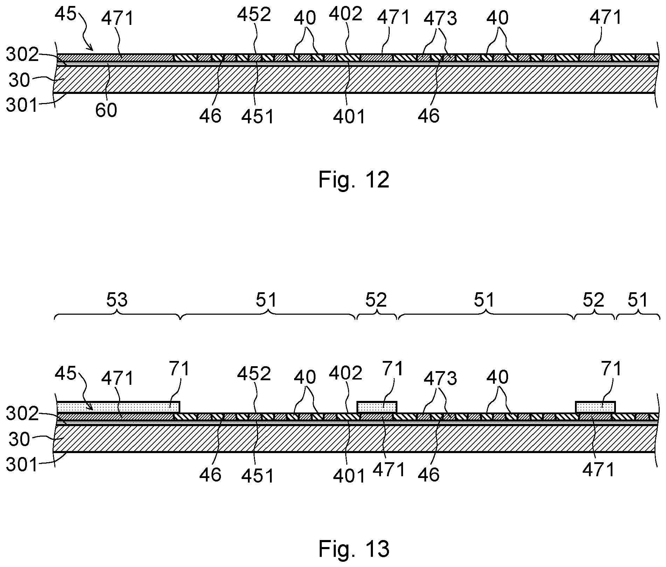

Subsequently, a first polishing step may be performed. The first polishing step involves polishing a part of each first metallic layer 40 protruding upward from the corresponding insulation opening 46. Fig. 12 is a cross-sectional view illustrating the polished first metallic layers 40.

The first polishing step may involve polishing the first metallic layers 40 by chemical mechanical polishing. The first polishing step may be performed until a polishing surface of a polishing tool reaches the second insulation surface 452 of the first insulation layer 45 in the thickness direction. As a result, the second metallic surface 402 of each first metallic layer 40 is located on the same plane as the second insulation surface 452 of the first insulation layer 45.

Subsequently, an insulation layer removal step for removing a part of the first insulation layer 45 is performed. As illustrated in Fig. 13, the insulation layer removal step may involve forming a first protection layer 71 that covers the frame section 471 of the first insulation layer 45. The first protection layer 71 does not have to cover the multiple island sections 473. The first protection layer 71 does not have to cover the first metallic layers 40 that surround the multiple island sections 473.

The first protection layer 71 has resistance against an etching solution used for removing the first insulation layer 45. For example, if the etching solution contains buffered hydrofluoric acid, the first protection layer 71 contains resin having resistance against hydrofluoric acid. For example, the first protection layer 71 contains photoresist having resistance against hydrofluoric acid. The photoresist may contain, for example, polyimide. A buffered hydrofluoric acid solution contains hydrofluoric acid and ammonium fluoride.

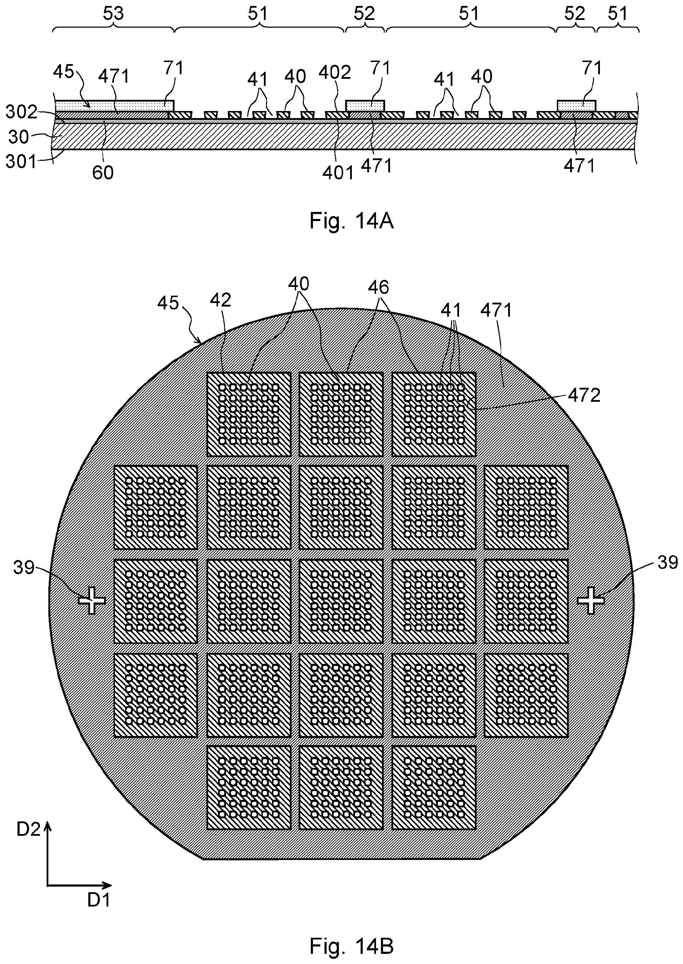

Subsequently, the insulation layer removal step involves supplying the etching solution, such as a buffered hydrofluoric acid solution, toward the first insulation layer 45. Accordingly, the multiple island sections 473 not covered by the first protection layer 71 are removed. Fig. 14A and Fig. 14B are a cross-sectional view and a plan view, respectively, illustrating the first insulation layer 45 in a state where the island sections 473 have been removed. After the island sections 473 are removed, a step for removing the first protection layer 71 may be performed.

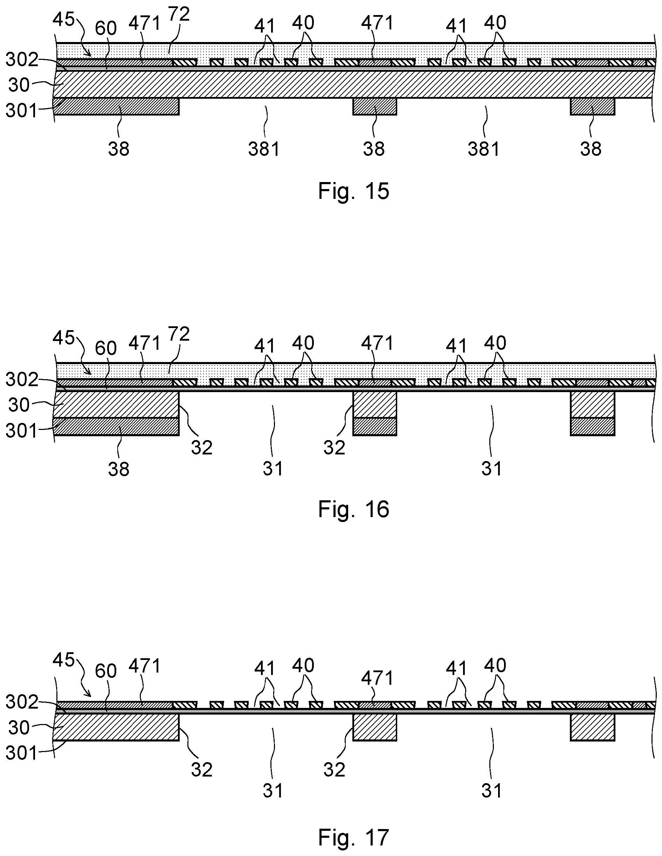

Then, a substrate processing step for forming the first openings 31 in the substrate 30 is performed. As illustrated in Fig. 15, the substrate processing step may involve forming a resist layer 38 partially on the first substrate surface 301. The resist layer 38 is provided with resist openings 381 that face the first openings 31. As illustrated in Fig. 15, a second protection layer 72 that covers the first metallic layers 40 and the first insulation layer 45 may be formed.

The resist layer 38 may be photoresist. In this case, the resist layer 38 is first formed on the first substrate surface 301 by coating the first substrate surface 301 with a liquid resist material. After the coating, a step for heating the resist layer 38 may be performed. Then, a photolithography process involving exposing the resist layer 38 to light and developing the resist layer 38 is performed. Consequently, the resist openings 381 can be formed in the resist layer 38.

Although not illustrated, the resist layer 38 may be a silicon oxide film partially formed on the first substrate surface 301. For example, the silicon oxide film is formed by performing a thermal oxidation process partially on the first substrate surface 301. The silicon oxide film may be formed on the substrate 30 before the intermediate layer 60 is stacked on the substrate 30.

Subsequently, as illustrated in Fig. 16, the substrate processing step involves forming the first openings 31 in the substrate 30 by etching the substrate 30 from the first substrate surface 301 side. The etching may be dry etching using etching gas. As illustrated in Fig. 16, since the intermediate layer 60 has resistance against an etchant, a situation where the etching progresses to the first metallic layers 40 can be suppressed. The etching gas is, for example, SF₆ gas.

Subsequently, a resist removal step for removing the resist layer 38, a protection layer removal step for removing the second protection layer 72, and an intermediate layer removal step for removing the intermediate layer 60 are performed. The order of the resist removal step, the protection layer removal step, and the intermediate layer removal step is not particularly limited. Fig. 17 is a cross-sectional view illustrating a state where the resist removal step and the protection layer removal step have been performed. Two or three of the resist removal step, the protection layer removal step, and the intermediate layer removal step may be performed at the same time.

If the resist layer 38 is photoresist, a resist processing solution containing N-methyl-2-pyrrolidone may be supplied toward the resist layer 38. The resist layer 38 may be removed by irradiating the resist layer 38 with oxygen plasma. If the resist layer 38 is a silicon oxide film, a resist processing solution containing hydrofluoric acid may be supplied toward the resist layer 38. The resist layer 38 may be removed by dry etching using, for example, CF₄ gas.

The removal of the intermediate layer 60 is performed by supplying the first openings 31 with an etchant for the intermediate layer 60. By supplying the first openings 31 with the etchant, the intermediate layer 60 overlapping the first openings 31 in plan view is removed. The removal of the intermediate layer 60 may be performed by dry etching using fluorine-based gas, or may be performed by wet etching using an acidic etching solution.

By removing the resist layer 38, the second protection layer 72, and the intermediate layer 60 overlapping the first openings 31, the mask 20 illustrated in Fig. 3 to Fig. 5 is obtained. The mask 20 includes the first metallic layers 40 located in the first regions 51 and the first insulation layer 45 located in the twenty-first region 52 and the twenty-second region 53. The first insulation layer 45 has internal-stress-related properties different from those of the first metallic layers 40. Thus, the first insulation layer 45 can at least partially cancel out a force applied to the substrate 30 by the first metallic layers 40. Consequently, an occurrence of warpage in the mask 20 can be suppressed.

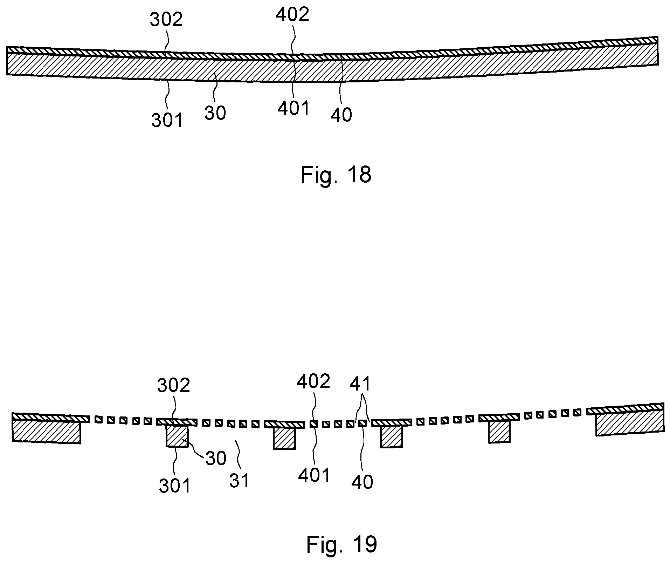

The effects of the mask 20 according to this embodiment will now be described based on a comparison with a comparative embodiment. Fig. 18 is a cross-sectional view illustrating a multilayer body including the substrate 30 and the first metallic layer 40.

The first metallic layer 40 is formed on the substrate 30 in an environment higher in temperature than room temperature. For example, the plating step or the annealing step is performed in the environment higher in temperature than room temperature. When the temperature of the substrate 30 and the first metallic layer 40 decreases to room temperature, compression occurs in the substrate 30 and the first metallic layer 40. If the thermal expansion coefficient of the first metallic layer 40 is larger than the thermal expansion coefficient of the substrate 30, the amount of compression occurring in the first metallic layer 40 is larger than the amount of compression occurring in the substrate 30. As a result, as illustrated in Fig. 18, the multilayer body has a curved shape that is convex in a direction extending from the second substrate surface 302 toward the first substrate surface 301. Specifically, warpage occurs in the multilayer body. The first metallic layer 40 is applying tensile stress to the substrate 30.

Fig. 19 is a cross-sectional view illustrating a mask manufactured by processing the multilayer body illustrated in Fig. 18. The mask illustrated in Fig. 19 is obtained by forming the first openings 31 in the substrate 30 and forming the second openings 41 in the first metallic layer 40 overlapping the first openings 31. Because the first metallic layer 40 applies tensile stress to the substrate 30, warpage also occurs in the mask.

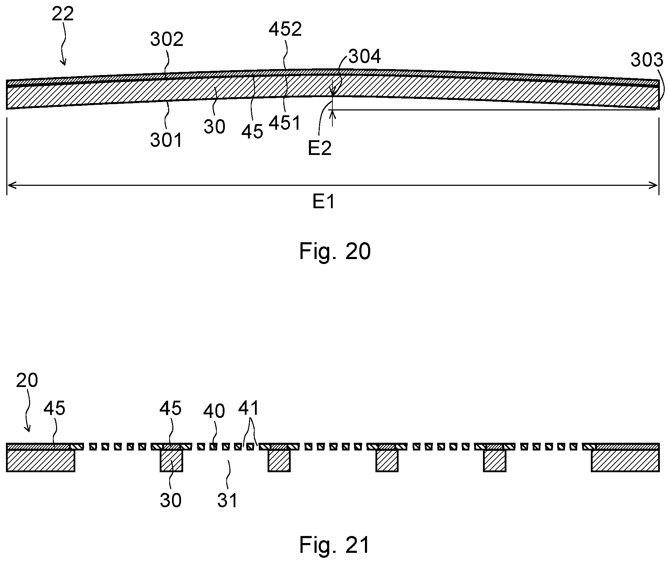

Fig. 20 is a cross-sectional view illustrating the aforementioned multilayer body 22 including the substrate 30 and the first insulation layer 45. The first insulation layer 45 is formed on the substrate 30 in an environment higher in temperature than room temperature. For example, a chemical vapor deposition step is performed in the environment higher in temperature than room temperature. When the temperature of the substrate 30 and the first insulation layer 45 decreases to room temperature, compression occurs in the substrate 30 and the first insulation layer 45. If the thermal expansion coefficient of the first insulation layer 45 is smaller than the thermal expansion coefficient of the substrate 30, the amount of compression occurring in the first insulation layer 45 is smaller than the amount of compression occurring in the substrate 30. As a result, as illustrated in Fig. 20, the multilayer body 22 has a curved shape that is convex in a direction extending from the first substrate surface 301 toward the second substrate surface 302. Specifically, warpage occurs in the multilayer body. The first insulation layer 45 is applying compressive stress to the substrate 30.

In Fig. 20, reference sign E1 denotes a dimension of the substrate 30 in the planar direction of the first substrate surface 301 of the substrate 30. Reference sign E2 denotes an amount of warpage occurring in the multilayer body 22. The warpage amount E2 is the distance between the outer edge 303 of the first substrate surface 301 and a center point 304 of the first substrate surface 301 in the thickness direction of the substrate 30.

Fig. 21 is a cross-sectional view illustrating an example of the mask 20 according to this embodiment. Compressive stress applied to the substrate 30 by the first insulation layer 45 can at least partially cancel out tensile stress applied to the substrate 30 by the first metallic layers 40. Consequently, an occurrence of warpage in the mask 20 can be suppressed.

The above-described embodiment can be modified in various ways. Modifications will now be described with reference to the drawings, where necessary. In the following description and the drawings used for the following description, sections that may be similar to those in the above-described embodiment are given the same reference signs as the reference signs used for the corresponding sections in the above-described embodiment. Redundant descriptions will be omitted. If the effects obtained in the above-described embodiment are obviously obtained also in the modifications, the descriptions thereof may sometimes be omitted.

### (First Modification)

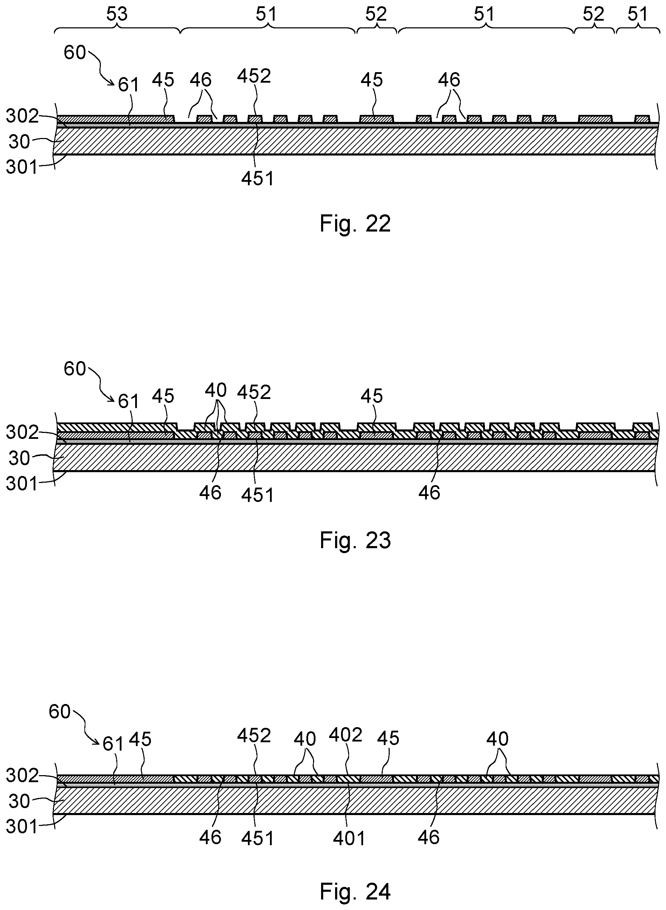

An example where the first metallic layers 40 are formed by physical deposition will now be described. Fig. 22 to Fig. 24 are diagrams for explaining a manufacturing method for a mask 20 according to a first modification.

Similar to the above-described embodiment, the intermediate layer 60 and the first insulation layer 45 are formed on the substrate 30. As illustrated in Fig. 22, the intermediate layer 60 may include the stopper layer 61. The intermediate layer 60 does not have to include the seed layer 62. The insulation openings 46 are formed in the first insulation layer 45.

Subsequently, as illustrated in Fig .23, the first-metallic-layer forming step for forming the first metallic layers 40 in the respective insulation openings 46 is performed. The first-metallic-layer forming step includes a physical deposition step for forming the first metallic layers 40 by physical deposition. Examples of the physical deposition include sputtering, vapor deposition, and ion plating. As illustrated in Fig. 23, the physical deposition step may involve forming the first metallic layers 40 not only in the insulation openings 46 but also on the first insulation layer 45.

Then, as illustrated in Fig. 24, the first polishing step may be performed. The first polishing step involves polishing a part of each first metallic layer 40 protruding upward from the corresponding insulation opening 46. The first polishing step may involve polishing the first metallic layers 40 located on the first insulation layer 45. Similar to the above-described embodiment, the first polishing step may involve polishing the first metallic layers 40 by chemical mechanical polishing. Fig. 24 is a cross-sectional view illustrating the polished first metallic layers 40.

Subsequently, similar to the above-described embodiment, the first insulation layer 45 surrounded by the first metallic layers 40 is removed, the first openings 31 are formed in the substrate 30, and the intermediate layer 60 overlapping the first openings 31 is removed, whereby the mask 20 is obtained.

In the first modification as well, compressive stress applied to the substrate 30 by the first insulation layer 45 can at least partially cancel out tensile stress applied to the substrate 30 by the first metallic layers 40. Consequently, an occurrence of warpage in the mask 20 can be suppressed.

The physical deposition enables the first metallic layers 40 to have a more uniform thickness, as compared with plating. Thus, the load of the first polishing step can be reduced. For example, the time required for the first polishing step can be reduced.

### (Second Modification)

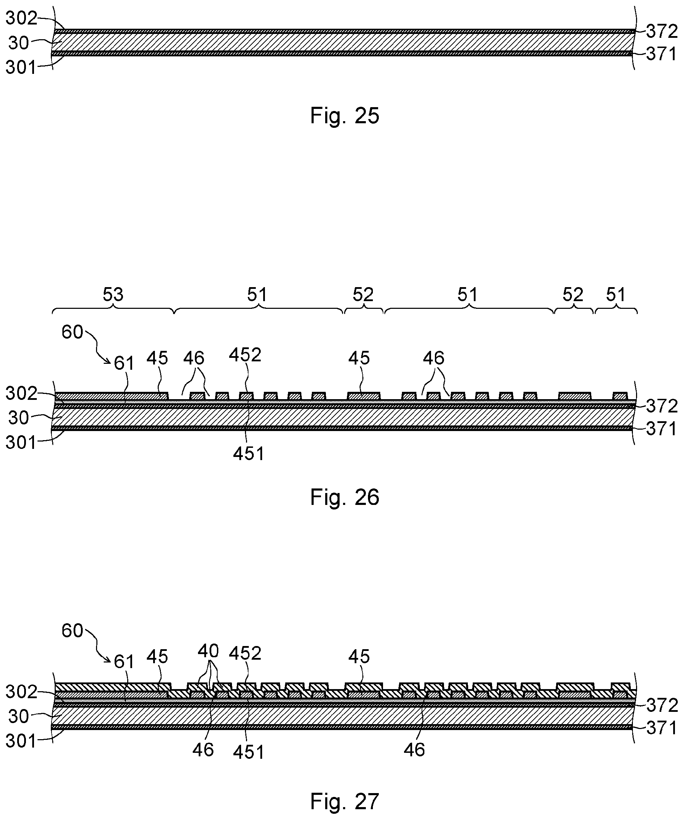

An example where the substrate 30 includes an oxide film on the surface thereof will now be described. Fig. 25 to Fig. 29 are diagrams for explaining a manufacturing method for a mask 20 according to a second modification.

Fig. 25 is a cross-sectional view illustrating an example of the substrate preparation step for preparing the substrate 30. The substrate 30 may include a first oxide film 371 constituting the first substrate surface 301 and a second oxide film 372 constituting the second substrate surface 302. Although not illustrated, the substrate 30 may include an oxide film constituting a side surface of the substrate 30. These oxide films may be formed by performing a thermal oxidation process on the substrate 30. The thermal oxidation process involves oxidizing a surface of the substrate 30 by heating the substrate 30.

Subsequently, similar to the above-described embodiment, the intermediate layer 60 and the first insulation layer 45 are formed on the substrate 30. As illustrated in Fig. 26, the insulation openings 46 are formed in the first insulation layer 45.

Then, as illustrated in Fig. 27, the first-metallic-layer forming step for forming the first metallic layers 40 in the respective insulation openings 46 is performed. Similar to the first modification, the first-metallic-layer forming step may include a physical deposition step. Although not illustrated, similar to the above-described embodiment, the first-metallic-layer forming step may include a plating step.

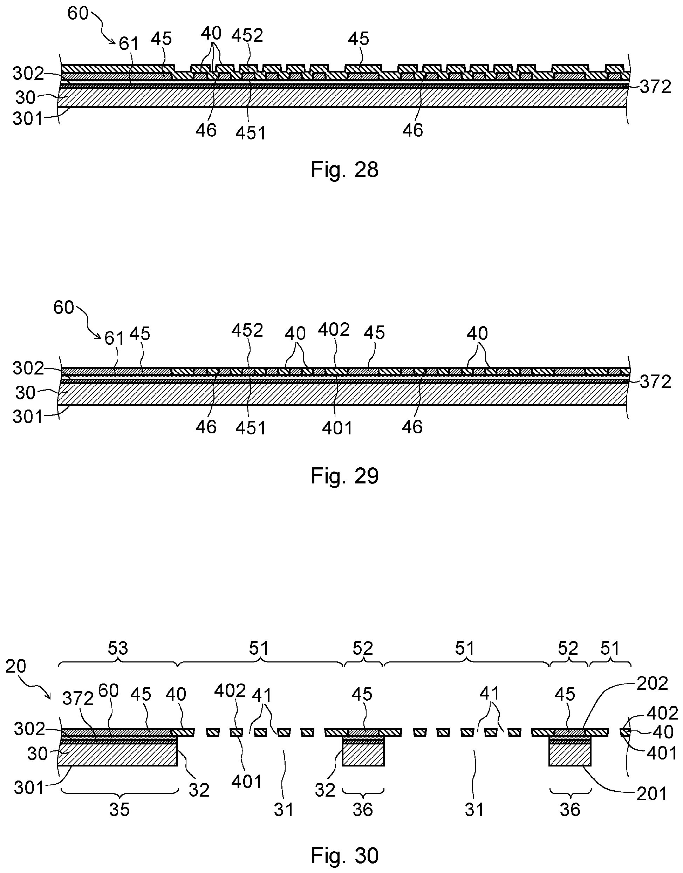

Subsequently, as illustrated in Fig. 28, a step for removing the first oxide film 371 may be performed. Accordingly, the first substrate surface 301 constituted of silicon instead of an oxide film is obtained.

Then, as illustrated in Fig. 29, the first polishing step may be performed. Although not illustrated, the first polishing step may be performed prior to the step for removing the first oxide film 371.

Subsequently, similar to the above-described embodiment, the first insulation layer 45 surrounded by the first metallic layers 40 is removed, the first openings 31 are formed in the substrate 30, and the intermediate layer 60 overlapping the first openings 31 is removed, whereby the mask 20 is obtained. Fig. 30 is a cross-sectional view illustrating an example of the mask 20 according to the second modification. The mask 20 may include the second oxide film 372 constituting the second substrate surface 302 of the substrate 30.

The second oxide film 372 may function to cause compressive stress to occur in the substrate 30. In this case, the second oxide film 372 can function to at least partially cancel out tensile stress applied to the substrate 30 by the first metallic layers 40. Specifically, the second oxide film 372 can reinforce the function of the first insulation layer 45. The second modification facilitates the adjustment of the balance between tensile stress and compressive stress applied to the substrate 30.

### (Third Modification)

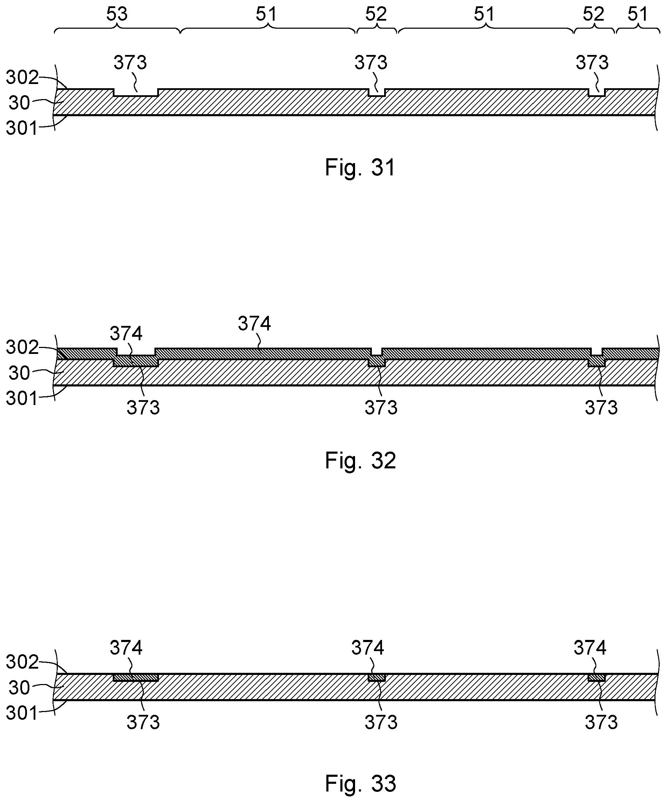

An example where the substrate 30 partially includes a second insulation layer will now be described. Fig. 31 to Fig. 34 are diagrams for explaining a manufacturing method for a mask 20 according to a third modification.

Fig. 31 is a cross-sectional view illustrating an example of the substrate preparation step for preparing the substrate 30. The substrate preparation step includes a step for forming recesses 373 in the second substrate surface 302 of the substrate 30. The recesses 373 are formed in the second substrate surface 302 of the substrate 30 corresponding to the twenty-first region 52 and the twenty-second region 53.

The recesses 373 may be formed by dry etching using etching gas. The dry etching may be reactive ion etching. The reactive ion etching may be deep reactive ion etching, that is, so-called DRIE. For example, the depth of each recess 373 is 1.0 µm or more, may be 2.0 µm or more, or may be 3.0 µm or more. For example, the depth of each recess 373 is 10.0 µm or less, may be 8.0 µm or less, or may be 5.0 µm or less.

Subsequently, as illustrated in Fig. 32, a step for forming a second insulation layer 374 in the recesses 373 is performed. The second insulation layer 374 formed in the recesses 373 may protrude upward from the recesses 373. Specifically, the upper surface of the second insulation layer 374 may be located higher than the second substrate surface 302 of the substrate 30. As illustrated in Fig. 32, the second insulation layer 374 may be formed also on the second substrate surface 302.

Similar to the first insulation layer 45, the material of the second insulation layer 374 is selected such that the second insulation layer 374 has internal-stress-related properties different from those of the first metallic layer 40. The material of the second insulation layer 374 has insulating properties. For example, the second insulation layer 374 contains an oxide having insulating properties. The oxide is, for example, a silicon oxide.

Similar to the first insulation layer 45, the second insulation layer 374 may be formed by chemical vapor deposition. For example, the second insulation layer 374 may be formed by chemical vapor deposition using TEOS as a raw material.

Subsequently, as illustrated in Fig. 33, a second polishing step may be performed. The second polishing step involves polishing a part of the second insulation layer 374 protruding upward from each recess 373. The second polishing step may involve polishing the second insulation layer 374 located on the second substrate surface 302. Similar to the first polishing step, the second polishing step may involve polishing the second insulation layer 374 by chemical mechanical polishing. The second polishing step may involve polishing the second insulation layer 374 by a method other than chemical mechanical polishing.

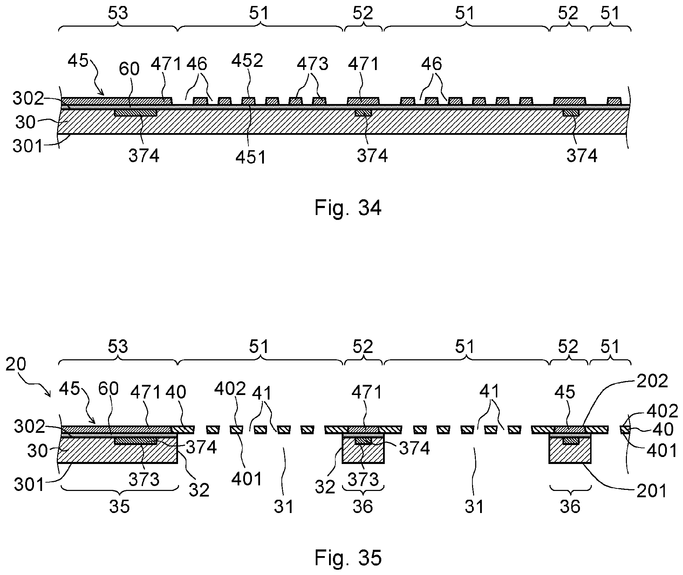

Then, similar to the above-described embodiment, the intermediate layer 60 and the first insulation layer 45 are formed on the substrate 30. As illustrated in Fig. 34, the insulation openings 46 are formed in the first insulation layer 45.

Subsequently, similar to the above-described embodiment, the first metallic layers 40 are formed in the respective insulation openings 46, the first insulation layer 45 surrounded by the first metallic layers 40 is removed, the first openings 31 are formed in the substrate 30, and the intermediate layer 60 overlapping the first openings 31 is removed, whereby the mask 20 is obtained. Fig. 35 is a cross-sectional view illustrating an example of the mask 20 according to the third modification. The mask 20 may include the recesses 373 located in the second substrate surface 302 in the twenty-first region 52 and the twenty-second region 53, and the second insulation layer 374 located in the recesses 373.

Although not illustrated, the mask 20 includes the recesses 373 and the second insulation layer 374 located in the twenty-first region 52, but does not have to include the recesses 373 and the second insulation layer 374 located in the twenty-second region 53. Although not illustrated, the mask 20 includes the recesses 373 and the second insulation layer 374 located in the twenty-second region 53, but does not have to include the recesses 373 and the second insulation layer 374 located in the twenty-first region 52.

The second insulation layer 374 may function to cause compressive stress to occur in the substrate 30. In this case, the second insulation layer 374 can function to at least partially cancel out tensile stress applied to the substrate 30 by the first metallic layers 40. Specifically, the second insulation layer 374 can reinforce the function of the first insulation layer 45. The third modification facilitates the adjustment of the balance between tensile stress and compressive stress applied to the substrate 30.

### (Fourth Modification)

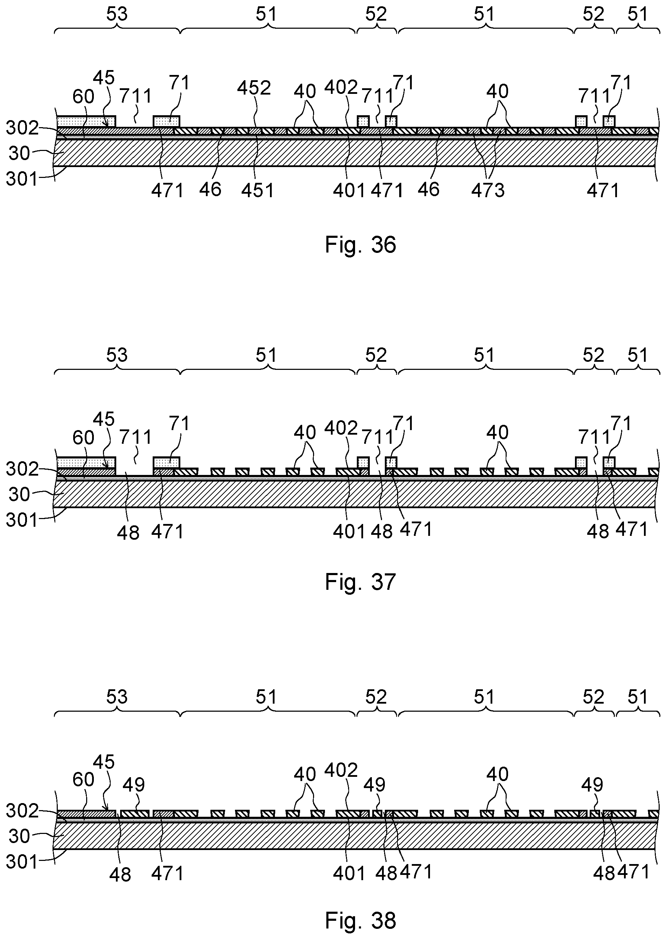

An example where the mask 20 includes a second metallic layer will now be described. Fig. 36 to Fig. 38 are diagrams for explaining a manufacturing method for a mask 20 according to a fourth modification.

The fourth modification is similar to the above-described embodiment or each modification in that the first metallic layers 40 are formed in the insulation openings 46 in the first insulation layer 45. Subsequently, an insulation layer removal step for partially removing the first insulation layer 45 is performed.

Fig. 36 is a cross-sectional view illustrating a state where the first protection layer 71 for protecting the unremoved first insulation layer 45 is formed. As illustrated in Fig. 36, openings 711 may be partially formed in the first protection layer 71 on the frame section 471.

Subsequently, the insulation layer removal step involves supplying an etching solution, such as a buffered hydrofluoric acid solution, toward the first insulation layer 45. Accordingly, the first insulation layer 45 not covered by the first protection layer 71 is removed. In detail, multiple island sections 473 and parts of the frame section 471 are removed. As a result, as illustrated in Fig. 37, openings 48 are formed in the parts of the frame section 471. The openings 48 formed in the frame section 471 are also referred to as third openings. The third openings 48 extend through from the first insulation surface 451 to the second insulation surface 452.

Then, as illustrated in Fig. 38, a step for forming second metallic layers 49 in the third openings 48 is performed. The method for forming the second metallic layers 49 is not particularly limited. For example, the second metallic layers 49 may be formed by plating, may be formed by physical deposition, or may be formed by printing. The second metallic layers 49 may be in contact with the frame section 471, or does not have to be in contact with the frame section 471.

The second metallic layers 49 contain metal. The metal may be a magnetic material or a nonmagnetic material. Examples of the magnetic material include nickel, iron, cobalt, and an alloy thereof. Examples of the nonmagnetic material include copper, titanium, chromium, and an alloy thereof. Preferably, the second metallic layers 49 contain a magnetic material.

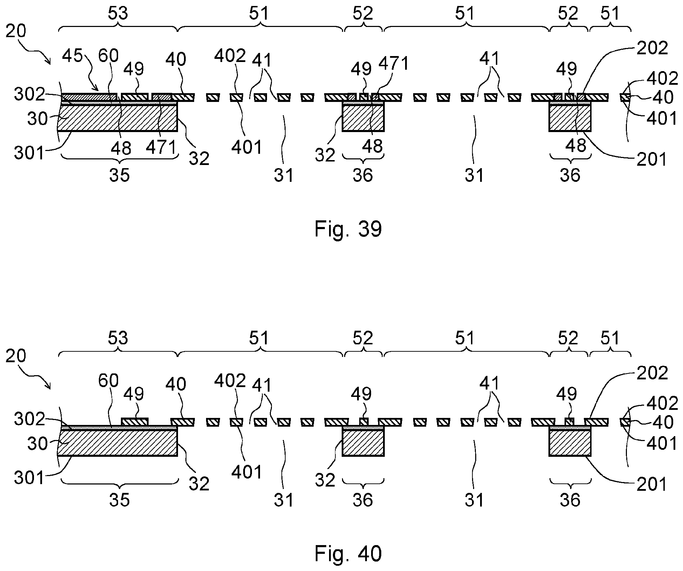

Subsequently, similar to the above-described embodiment, the first openings 31 are formed in the substrate 30, and the intermediate layer 60 overlapping the first openings 31 is removed, whereby the mask 20 is obtained. Fig. 39 is a cross-sectional view illustrating an example of the mask 20 according to the fourth modification. The mask 20 may include the second metallic layers 49 located in the third openings 48 in the frame section 471 of the first insulation layer 45.

If the second metallic layers 49 contain a magnetic material, a force that attracts the second metallic layers 49 to the magnet 5 occurs in the vapor deposition apparatus 10. This enables a gap to be reduced or eliminated between the mask 20 and the substrate 110.

Fig. 40 is a cross-sectional view illustrating an example of the mask 20 according to the fourth modification. As illustrated in Fig. 40, the mask 20 does not have to include the first insulation layer 45. For example, the above-described insulation layer removal step may involve removing the entire first insulation layer 45. The mask 20 may include the second metallic layer 49 located in the twenty-second region 53. In the mask 20 illustrated in Fig. 40, two of the first metallic layers 40 overlapping two of the first openings 31 adjacent to each other in plan view are not connected, so that tensile stress applied to the substrate 30 by the first metallic layers 40 can be reduced, as compared with the mask according to the comparative embodiment illustrated in Fig. 21.

### (Fifth Modification)

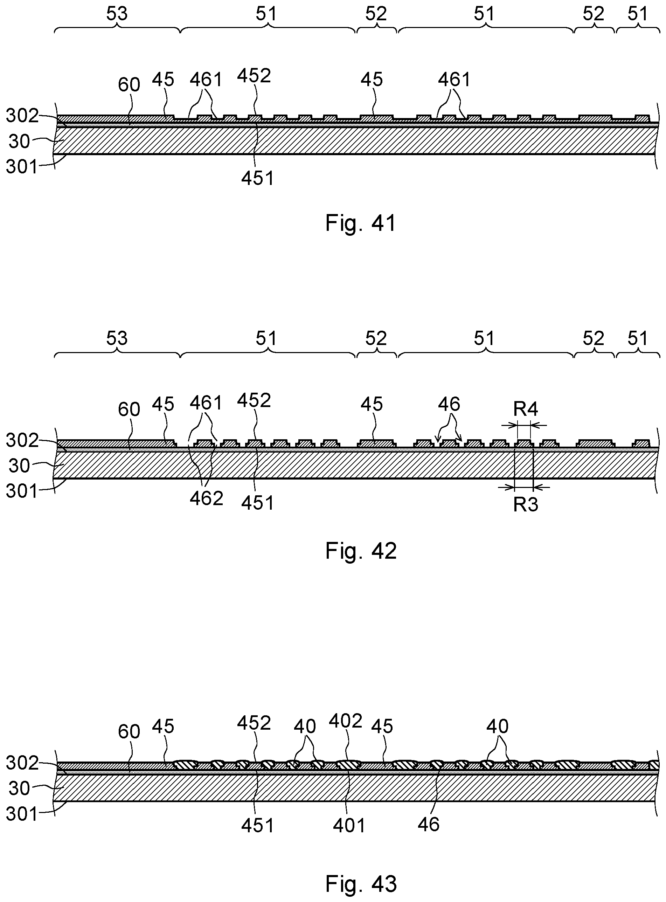

An example where the insulation openings 46 in the first insulation layer 45 are formed by two or more etching steps will now be described. Fig. 41 to Fig. 43 are diagrams for explaining a manufacturing method for a mask 20 according to a fifth modification.

The fifth modification is similar to the above-described embodiment or each modification in that the intermediate layer 60 is formed on the second substrate surface 302 of the substrate 30 and that the first insulation layer 45 is formed on the intermediate layer 60. Then, a first-insulation-layer processing step for forming the insulation openings 46 in the first insulation layer 45 is performed.

As illustrated in Fig. 41, the first-insulation-layer processing step may include a step for forming first holes 461 in the second insulation surface 452. The first holes 461 are formed in the first insulation layer 45 corresponding to each first region 51. The first holes 461 are formed so as not to reach the first insulation surface 451, that is, not to extend through the first insulation layer 45.

As illustrated in Fig. 42, the first-insulation-layer processing step may include a step for forming second holes 462 extending from the first holes 461 to the first insulation surface 451. Accordingly, the insulation openings 46 including the first holes 461 and the second holes 462 are formed in the first insulation layer 45. As illustrated in Fig. 42, each second hole 462 has a dimension smaller than the dimension of each first hole 461 in the planar direction of the first substrate surface 301. Accordingly, as illustrated in Fig. 42, the first insulation layer 45 having the third dimension R3 at the first insulation surface 451 and having the fourth dimension R4 at the second insulation surface 452 is formed in each first region 51. The fourth dimension R4 is smaller than the third dimension R3.

Subsequently, as illustrated in Fig. 43, the first-metallic-layer forming step for forming the first metallic layers 40 in the respective insulation openings 46 is performed. The first-metallic-layer forming step may include a plating step, or may include a physical deposition step.

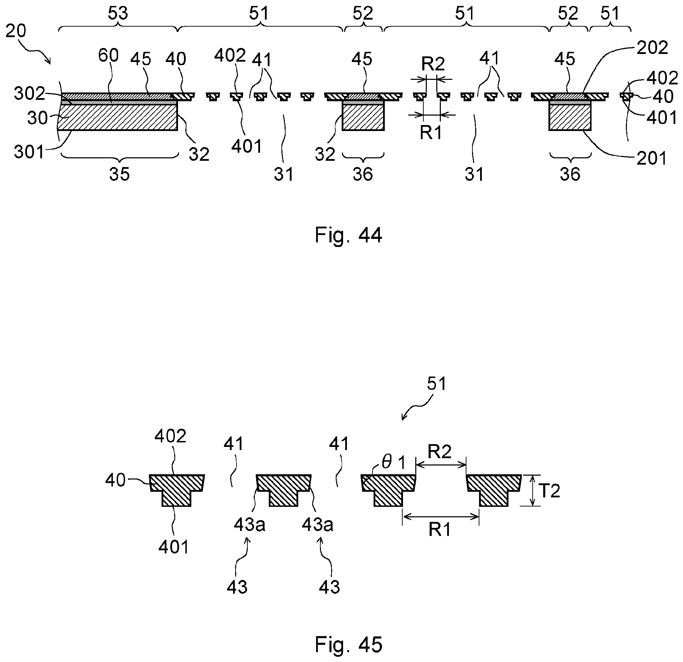

Then, the first polishing step may be performed. Subsequently, similar to the above-described embodiment, the first insulation layer 45 surrounded by the first metallic layers 40 is removed, the first openings 31 are formed in the substrate 30, and the intermediate layer 60 overlapping the first openings 31 is removed, whereby the mask 20 is obtained. Fig. 44 is a cross-sectional view illustrating an example of the mask 20 according to the fifth modification. In the first regions 51, the mask 20 includes the first metallic layers 40 having a shape corresponding to the insulation openings 46 in the first metallic layers 40.

Fig. 45 is a cross-sectional view illustrating an example of the first region 51. The metallic inner wall surface 43 of each first metallic layer 40 may have a step. The step occurs in accordance with a difference between the dimension of the first hole 461 and the dimension of the second hole 462 in each insulation opening 46. With the step, the first dimension R1 of the second opening 41 at the first metallic surface 401 can be made larger than the second dimension R2 of the second opening 41 at the second metallic surface 402.

### (Sixth Modification)

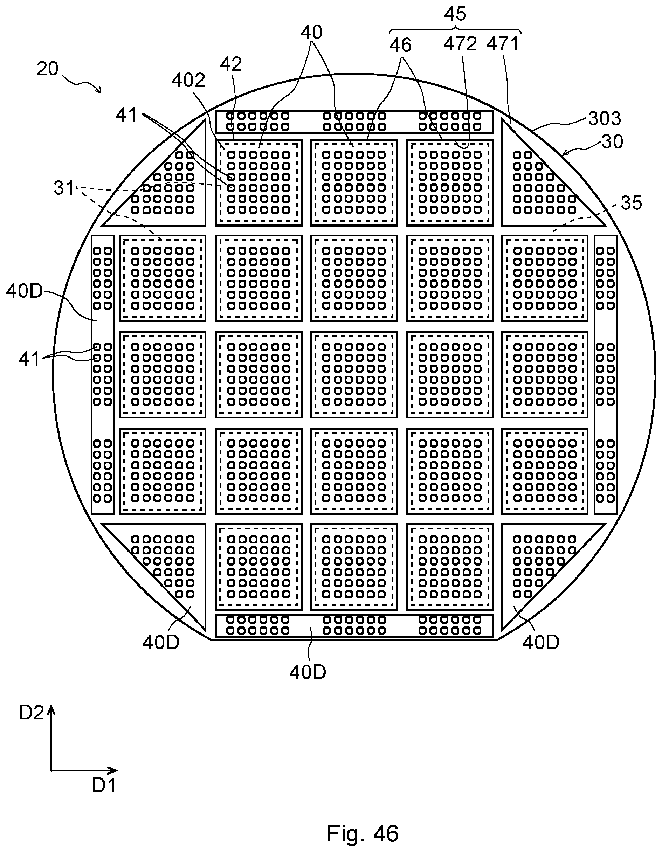

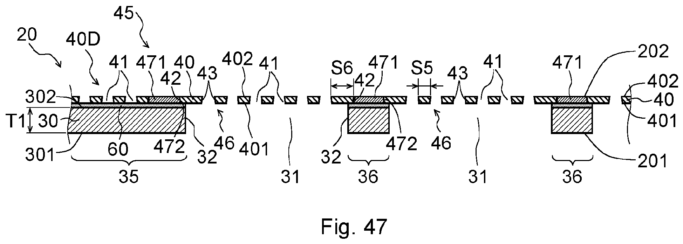

Fig. 46 and Fig. 47 are a plan view and a cross-sectional view, respectively, illustrating an example of a mask 20 according to a sixth modification. As illustrated in Fig. 46, the mask 20 may include the first metallic layers 40 located in the outer region 35 of the substrate 30. The first metallic layers 40 located in the outer region 35 are also referred to as dummy first metallic layers and are each denoted by reference sign 40D.

As illustrated in Fig. 46, in plan view, the dummy first metallic layers 40D are located between the first metallic layers 40 including the second openings 41 overlapping the first openings 31 and the outer edge 303 of the substrate 30. This implies that, in plan view, the dummy first metallic layers 40D are located outside the second openings 41 overlapping the first openings 31.

As illustrated in Fig. 46 and Fig. 47, each dummy first metallic layer 40D may have the second openings 41 extending through the first metallic layer 40. The second openings 41 in the dummy first metallic layer 40D do not have to overlap the first openings 31 in the substrate 30 in plan view.

As illustrated in Fig. 46 and Fig. 47, in plan view, the dummy first metallic layers 40D may be distant from the first metallic layers 40 including the second openings 41 overlapping the first openings 31. As illustrated in Fig. 46 and Fig. 47, the first insulation layer 45 may be located between the dummy first metallic layers 40D and the first metallic layers 40.

Although not illustrated, the dummy first metallic layers 40D including the second openings 41 not overlapping the first openings 31 and the first metallic layers 40 including the second openings 41 overlapping the first openings 31 may be connected in plan view.

When the first metallic layers 40 are polished by chemical mechanical polishing, the thickness of the polished first metallic layers 40 may sometimes vary depending on the locations of the first metallic layers 40. For example, when the multiple first metallic layers 40 are distributed on the substrate 30, the thickness of the first metallic layer 40 near the outer edge 303 of the substrate 30 may sometimes be larger than the thickness of the first metallic layer 40 near the center point of the substrate 30. In other words, the first metallic layer 40 near the outer edge 303 of the substrate 30 may sometimes be polished insufficiently.

In this modification, the dummy first metallic layers 40D are located outside the first metallic layers 40 including the second openings 41 overlapping the first openings 31. Thus, insufficiently polished regions tend to occur in the dummy first metallic layers 40D than in the first metallic layers 40 including the second openings 41 overlapping the first openings 31. Accordingly, this modification can suppress a situation where the first metallic layers 40 including the second openings 41 overlapping the first openings 31 are insufficiently polished.

### (Seventh Modification)

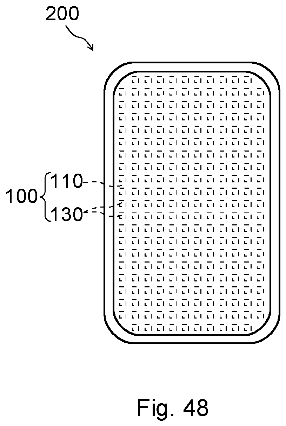

Fig. 48 illustrates an example of a device 200 including the organic device 100. The device 200 includes the substrate 110 and the organic layers 130. The organic layers 130 are formed by vapor deposition using the mask 20. An example of the device 200 is a smartphone. The device 200 may be, for example, a tablet terminal or a wearable terminal. Examples of the wearable terminal include smart glasses and a head-mounted display.

Multiple components disclosed in the above embodiment and modifications can be appropriately combined, where necessary. Alternatively, some of the components may be removed from all of the components disclosed in the above embodiment and modifications.

### EXAMPLE

Although the embodiment of the present disclosure will be described below in further detail with reference to an example, the embodiment of the present disclosure is not to be limited to the following example so long as it does not depart from the scope of the embodiment of the present disclosure.

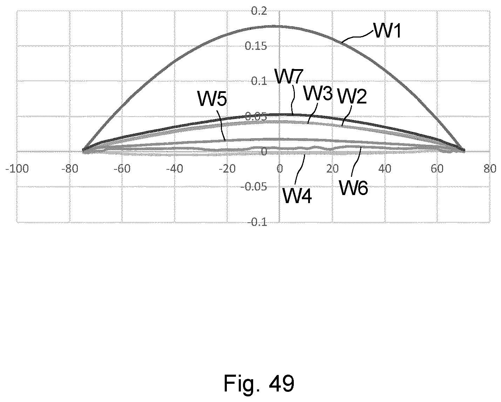

In each of the steps for manufacturing the aforementioned mask 20, the shape of warpage occurring in the substrate 30 is observed. The substrate 30 used is a silicon wafer having the thickness T1 of 625 µm and the dimension S1 of 152.4 mm. Observation results are illustrated in Fig. 49. In a graph illustrated in Fig. 49, the abscissa axis denotes the position of the first substrate surface 301 in the planar direction of the substrate 30, whereas the ordinate axis denotes the position of the first substrate surface 301 in the thickness direction of the substrate 30. The numerical unit on the ordinate axis and the numerical unit on the abscissa axis are both millimeters.

Reference sign W1 denotes a shape of the first substrate surface 301 in a state where the multilayer body includes the substrate 30 and the first insulation layer 45. The first insulation layer 45 is applying compressive stress to the substrate 30. Thus, the substrate 30 has a curved shape that is convex in the direction extending from the first substrate surface 301 toward the second substrate surface 302.

Reference sign W2 denotes a shape of the first substrate surface 301 in a state where the insulation openings 46 have been formed in the first insulation layer 45. Since the first insulation layer 45 is reduced in volume, the amount of warpage is reduced.

Reference sign W3 denotes a shape of the first substrate surface 301 in a state where the first metallic layers 40 have been formed in the insulation openings 46. Reference sign W4 denotes a shape of the first substrate surface 301 in a state where the annealing step for heating the first metallic layers 40 has been performed and the temperature has subsequently been returned to room temperature. In the shape W4, the curved shape according to the shape W1 has been resolved. The compressive stress applied to the substrate 30 by the first insulation layer 45 has conceivably been canceled out by the first metallic layers 40.

Reference sign W5 denotes a shape of the first substrate surface 301 in a state where the first polishing step has been performed. Reference sign W6 denotes a shape of the first substrate surface 301 in a state where the multiple island sections 473 of the first insulation layer 45 have been removed. Reference sign W7 denotes a shape of the first substrate surface 301 in a state where the first openings 31 have been formed in the substrate 30. Specifically, reference sign W7 denotes the shape of the first substrate surface 301 in the state of the mask 20.

As illustrated in Fig. 49, the amount of warpage occurring in the first substrate surface 301 in the state of the mask 20 is reduced to 0.10 mm or less, and is specifically reduced to about 0.05 mm.

## Claims

1. A mask manufacturing method comprising:
a substrate preparation step for preparing a substrate including a first substrate surface and a second substrate surface located opposite the first substrate surface;
a first-insulation-layer forming step for forming a first insulation layer including a first insulation surface facing the second substrate surface, a second insulation surface located opposite the first insulation surface, and an insulation opening extending through from the first insulation surface to the second insulation surface;
a first-metallic-layer forming step for forming a first metallic layer in the insulation opening, the first metallic layer including a first metallic surface facing the second substrate surface and a second metallic surface located opposite the first metallic surface;
an insulation layer removal step for removing sections of the first insulation layer surrounded by the first metallic layer in plan view; and
a substrate processing step for forming a first opening in the substrate, the first opening overlapping the first metallic layer in plan view.

2. The mask manufacturing method according to claim 1, wherein the mask includes an intermediate layer containing metal, the intermediate layer being located between the first metallic surface and the second substrate surface as well as between the first insulation surface and the second substrate surface.

3. The mask manufacturing method according to claim 2, further comprising an intermediate layer removal step for removing the intermediate layer overlapping the first opening in plan view, the intermediate layer removal step being performed subsequent to the substrate processing step.

4. The mask manufacturing method according to claim 1, wherein the first-metallic-layer forming step includes a plating step.

5. The mask manufacturing method according to claim 1, wherein the first-metallic-layer forming step includes a physical deposition step.

6. The mask manufacturing method according to any one of claims 1 to 5, further comprising a first polishing step for polishing a part of the first metallic layer, the part protruding from the insulation opening, the first polishing step being performed subsequent to the first-metallic-layer forming step.

7. The mask manufacturing method according to any one of claims 1 to 5, further comprising a step for forming a protection layer covering the first metallic layer, the step being performed subsequent to the insulation layer removal step and prior to the substrate processing step.

8. The mask manufacturing method according to any one of claims 1 to 5, wherein the first insulation layer surrounded by the insulation opening in plan view has a third dimension at the first insulation surface and has a fourth dimension at the second insulation surface, the fourth dimension being smaller than the third dimension.

9. The mask manufacturing method according to claim 8, wherein the first-insulation-layer forming step includes a step for forming a first hole in the second insulation surface and a step for forming a second hole extending from the first hole to the first insulation surface.

10. The mask manufacturing method according to any one of claims 1 to 5, wherein a multilayer body including the substrate and the first insulation layer has a curved shape that is convex in a direction extending from the first substrate surface toward the second substrate surface.

11. A mask comprising:
a substrate including a first substrate surface, a second substrate surface located opposite the first substrate surface, and at least one first opening extending through from the first substrate surface to the second substrate surface;
a first metallic layer including a first metallic surface that overlaps the first opening in plan view and that partially faces the second substrate surface, a second metallic surface located opposite the first metallic surface, a plurality of second openings that extend through from the first metallic surface to the second metallic surface and that overlap the first opening in plan view, and a metallic outer wall surface located between the first metallic surface and the second metallic surface; and
a first insulation layer including a first insulation surface facing the second substrate surface, a second insulation surface located opposite the first insulation surface, and an insulation wall surface that is located between the first insulation surface and the second insulation surface and that is in contact with the metallic outer wall surface.

12. The mask according to claim 11, further comprising an intermediate layer containing metal, the intermediate layer being located between the first metallic surface and the second substrate surface as well as between the first insulation surface and the second substrate surface.

13. The mask according to claim 11, wherein the substrate contains silicon or a silicon compound.

14. The mask according to claim 11, wherein the first insulation layer contains a silicon oxide.

15. The mask according to any one of claims 11 to 14, wherein the second metallic surface and the second insulation surface are located on the same plane.

16. The mask according to any one of claims 11 to 14, wherein each second opening has a first dimension at the first metallic surface and a second dimension at the second metallic surface, the second dimension being smaller than the first dimension.

17. The mask according to any one of claims 11 to 14, wherein the substrate includes a second oxide film constituting the second substrate surface.

18. The mask according to any one of claims 11 to 14, wherein the substrate includes a second insulation layer located in a recess formed in the second substrate surface.

19. The mask according to claim 18, wherein the second insulation layer contains a silicon oxide.

20. The mask according to any one of claims 11 to 14,
wherein the first insulation layer includes a third opening extending through from the first insulation surface to the second insulation surface, and
wherein the mask further comprises a second metallic layer located in the third opening.
